# EUROPEAN PATENT APPLICATION

(11) **EP 4 598 291 A1**
(43) Date of publication of application: **06.08.2025**
(21) Application number: 23878908.5
(22) Date of filing: 21.09.2023
(51) Int. Cl.: H05K 7/20

(54) **HEAT DISSIPATION DEVICE AND POWER CONVERTER**

(30) Priority: 21.10.2022 CN 202211296759
(71) Applicant: Huawei Digital Power Technologies Co., Ltd., Shenzhen, Guangdong 518043 (CN)
(72) Inventor: SUN, Faming, Shenzhen, Guangdong 518043 (CN); HUI, Xiaowei, Shenzhen, Guangdong 518043 (CN); MENG, Hao, Shenzhen, Guangdong 518043 (CN)
(74) Representative: Epping - Hermann - Fischer
(86) International application number: PCT/CN2023/120495
(87) International publication number: WO 2024/082915

(57) **Abstract**

This application provides a heat dissipation apparatus, including an evaporator and a condenser. The evaporator includes a housing and a division plate. The housing has a sealed inner cavity. The division plate divides the inner cavity into a first sub-cavity and a second sub-cavity. A first pipeline communicates with the first sub-cavity. A second pipeline communicates with the second sub-cavity. A heat emitting element is further fastened in the first sub-cavity. The division plate is provided with a flow guiding hole communicating with the first sub-cavity and the second sub-cavity. The flow guiding hole is provided facing the heat emitting element. A cooling working fluid in the condenser is transmitted to the second sub-cavity through the second pipeline. The cooling working fluid flows into the first sub-cavity through the flow guiding hole, and after dissipating heat for the heat emitting element, flows back to the condenser through the first pipeline for cooling. According to the heat dissipation apparatus in this application, a flow path of the cooling working fluid is limited, to ensure that the cooling working fluid is in full contact with the heat emitting element. This improves heat dissipation effect of the heat dissipation apparatus. This application further provides several heat dissipation apparatuses and a power converter including the foregoing heat dissipation apparatus.

## Description

This application claims priority to Chinese Patent Application No. 202211296759.X, filed with the China National Intellectual Property Administration on October 21, 2022 and entitled "HEAT DISSIPATION APPARATUS AND POWER CONVERTER", which is incorporated herein by reference in its entirety.

### TECHNICAL FIELD

This application relates to the field of electronic components, and in particular, to a heat dissipation apparatus and a power converter including the heat dissipation apparatus.

### BACKGROUND

A power converter, for example, an inverter, a motor driver, or an uninterruptible power supply, usually converts power by using a power semiconductor device. With development of the power semiconductor device toward integration and miniaturization, heat emitting energy consumption of the power semiconductor device gradually increases. Therefore, a heat dissipation capability of a heat dissipation apparatus in the power converter needs to be improved, to meet a working requirement of the power semiconductor device.

### SUMMARY

This application provides a heat dissipation apparatus and a power converter including the heat dissipation apparatus. An internal structure of the heat dissipation apparatus is disposed in a targeted manner, to improve a heat dissipation capability for a power semiconductor device. This application specifically includes the following technical solutions.

According to a first aspect, this application provides a heat dissipation apparatus, including an evaporator, a condenser, and a first pipeline and a second pipeline that separately communicate with the evaporator and the condenser. The evaporator includes a housing and a division plate. The housing has a sealed inner cavity. The division plate divides the inner cavity into a first sub-cavity and a second sub-cavity. The first pipeline communicates with the first sub-cavity. The second pipeline communicates with the second sub-cavity. A heat emitting element is further fastened in the first sub-cavity. The division plate is provided with a flow guiding hole configured for the first sub-cavity to communicate with the second sub-cavity. At least a part of the flow guiding hole directly faces the heat emitting element located in the first sub-cavity. A cooling working fluid in the condenser is transmitted to the second sub-cavity through the second pipeline. The cooling working fluid flows into the first sub-cavity through the flow guiding hole, and after dissipating heat for the heat emitting element, flows back to the condenser through the first pipeline for cooling. According to the heat dissipation apparatus provided in the first aspect of this application, a circulation channel is formed by the evaporator, the first pipeline, the condenser, and the second pipeline, so that the cooling working fluid circulates in the circulation channel. The cooling working fluid dissipates heat for the heat emitting element in the evaporator, is cooled in the condenser, and then returns to the evaporator.

According to the heat dissipation apparatus in this application, the division plate is further disposed, to limit a flow path of the cooling working fluid. When the cooling working fluid enters the first sub-cavity from the second sub-cavity, because at least a part of the flow guiding hole is provided directly facing the heat emitting element, it can be ensured that the cooling working fluid can dissipate heat for the heat emitting element through a short flow path, to ensure heat dissipation effect of the heat dissipation apparatus in this application for the heat emitting element.

In a possible implementation, the cooling working fluid in the condenser is transmitted to the second sub-cavity through the second pipeline under an action of gravity. The cooling working fluid flows into the first sub-cavity through the flow guiding hole against a gravity direction, and after dissipating heat for the heat emitting element, flows back to the condenser through the first pipeline against the gravity direction for cooling.

In this implementation, the condenser is located above the evaporator in the gravity direction. The cooling working fluid may be a gas-liquid two-phase cooling working fluid, for example, a coolant or water. When the cooling working fluid is transmitted to the second sub-cavity through the second pipeline under the action of gravity, the cooling working fluid may be in a liquid state. After dissipating heat for the heat emitting element, the cooling working fluid may be converted into gas, so that the cooling working fluid flows back to the condenser through the first pipeline against the gravity direction. According to the heat dissipation apparatus in this application, a form of a gravity heat pipe may be formed, and circulation of the cooling working fluid is implemented through phase transition of the cooling working fluid. This reduces energy consumption.

In a possible implementation, the condenser is provided with a liquid inlet communicating with the first pipeline and a liquid outlet communicating with the second pipeline. The liquid inlet is located above the liquid outlet in the gravity direction.

In this implementation, the cooling working fluid entering the condenser from the first pipeline has a high temperature, and may flow back to the upper condenser from the lower evaporator in the gravity direction. After being cooled in the condenser, the cooling working fluid flows back to the evaporator from the lower liquid outlet in the gravity direction.

In a possible implementation, the flow guiding hole includes a plurality of flow guiding sub-holes. The plurality of flow guiding sub-holes are spaced from each other and located between the heat emitting element and the division plate.

In this implementation, the plurality of flow guiding sub-holes are provided, so that the cooling working fluid can flow into the first sub-cavity evenly, and form good cooling effect for the heat emitting element. In addition, when a size of the flow guiding sub-hole is set to be small, the flow guiding sub-hole may further block a bubble, to prevent the bubble in the second sub-cavity from entering the first sub-cavity with the cooling working fluid, and prevent the bubble from affecting heat dissipation effect of the cooling working fluid for the heat emitting element.

In a possible implementation, the heat emitting element includes at least a first heat emitting element and a second heat emitting element. The second heat emitting element is located between the first heat emitting element and the division plate. The housing further includes a flow limiting plate. The flow limiting plate is located between the first heat emitting element and the second heat emitting element. The flow limiting plate is provided with a plurality of penetrated apertures. The apertures are configured to block a bubble flowing to the first heat emitting element.

In this implementation, a plurality of heat emitting elements may be disposed in the housing, and at least two heat emitting elements are arranged and spaced from each other in a same direction. The cooling working fluid flows through the second heat emitting element and the first heat emitting element in sequence, and dissipates heat for the second heat emitting element and the first heat emitting element in sequence. Because the cooling working fluid may generate a bubble when dissipating heat for the second heat emitting element, and the bubble flows toward the first heat emitting element with the cooling working fluid, the flow limiting plate is disposed between the first heat emitting element and the second heat emitting element, and the apertures are provided to block the bubble. This can ensure that the cooling working fluid passes through the apertures to dissipate heat for the first heat emitting element, and avoid affecting the heat dissipation effect because the bubble is in contact with the first heat emitting element.

In a possible implementation, the housing further includes a flow limiting wall. The flow limiting wall is fastened to the flow limiting plate and located on at least one side of the first heat emitting element. The flow limiting wall is also configured to block a bubble flowing to the first heat emitting element.

In this implementation, the flow limiting wall extends in a direction perpendicular to the flow limiting plate, and is located on a side of the first heat emitting element. When the bubble blocked by the flow limiting plate flows toward a side direction of the first heat emitting element, the flow limiting wall may further prevent the bubble from being in contact with the first heat emitting element on the side. This further ensures the heat dissipation effect for the first heat emitting element.

In a possible implementation, there are two flow limiting walls. The two flow limiting walls are respectively arranged on two opposite sides of the first heat emitting unit, and are respectively fastened to two opposite ends of the flow limiting wall.

In a possible implementation, the first sub-cavity is located above the second sub-cavity in the gravity direction.

In a possible implementation, the housing includes a front cover and a rear cover that are spaced from each other and fastened. The flow limiting plate and/or the flow limiting wall are/is fastened to both the front cover and the rear cover.

In a possible implementation, the flow limiting wall is also provided with a plurality of apertures. In this implementation, the apertures provided on the flow limiting wall can also block the bubble and allow the cooling working fluid on a side edge to pass through the flow limiting wall and act on the first heat emitting element.

In a possible implementation, the housing includes a front cover and a rear cover that are spaced from each other and fastened. The inner cavity is further provided with a plurality of support cradles spaced from each other. The heat emitting element is fastened to the front cover or the rear cover. Two opposite ends of each support cradle are respectively fastened to the front cover and the rear cover. The support cradles are configured to improve structural stability of the housing.

In this implementation, the support cradles may be located around the heat emitting element, and are connected between the front cover and the rear cover, to improve the structural stability of the housing. In addition, the support cradles may be disposed to form specific drainage effect and distribution effect for the cooling working fluid, so that the cooling working fluid flows more evenly and fully in the inner cavity.

In a possible implementation, the heat emitting element is fastened to an inner side wall of one of the front cover and the rear cover. An inner side wall of the other cover is provided with a fitting area. A position of the fitting area is at least partially aligned with that of the heat emitting element. The fitting area is provided with a bump. The bump protrudes toward the heat emitting element and is in contact with the heat emitting element. The bump further has a pore. The pore is at least located on an end surface that is of the bump and that is in contact with the heat emitting element. In this implementation, in the heat dissipation apparatus, the bump on the fitting area is provided, so that the pore of the bump abuts against and is in contact with the heat emitting element, and the cooling working fluid can form more nucleation points on a surface of the heat emitting element. This improves the heat dissipation effect of the cooling working fluid for the heat emitting element. In a possible implementation, there is a first distance between any two adjacent support cradles. The pore of the bump is formed by irregular arrangement of a plurality of holes. An inner diameter of any one of the holes is less than the first distance.

In a possible implementation, there is a first distance between any two adjacent support cradles. The bump includes a plurality of protruding portions spaced from each other. Gaps between the plurality of protruding portions form the pore. A distance between any two adjacent protruding portions is less than the first distance.

In the foregoing two implementations, the pore on the bump may be formed by the plurality of holes, or may be formed by the plurality of protruding portions spaced from each other. **In** addition, a spacing distance between pores is less than a spacing distance between the support cradles. This ensures that the nucleation points are located at the pore, and avoids affecting the heat dissipation effect of the cooling working fluid for the heat emitting element due to an excessively small spacing between the support cradles.

In a possible implementation, the housing is provided with a first communicating hole and a second communicating hole. The first pipeline communicates with the inner cavity through the first communicating hole. The second pipeline communicates with the inner cavity through the second communicating hole. The first communicating hole is located above the second communicating hole in the gravity direction.

In this implementation, after dissipating heat, the cooling working fluid may present a gas-liquid two-phase mixing state. In this case, the cooling working fluid in the gas state flows upward in the inner cavity, and therefore may enter the first pipeline through the first communicating hole at a high position, and flow back to the condenser for cooling.

In a possible implementation, the first communicating hole is located at the top of the housing in the gravity direction.

In a possible implementation, the heat dissipation apparatus includes a water pump. A pump port of the water pump communicates with the first pipeline and/or the second pipeline. The water pump is configured to drive circulation of the cooling working fluid.

In this implementation, the water pump is disposed, so that a flow direction of the cooling working fluid in the heat dissipation apparatus can be further controlled. The heat emitting element may be arranged randomly based on an actual usage scenario and disposed in cooperation with the flow direction of the cooling working fluid, so that the heat emitting element obtains better heat dissipation effect.

According to a second aspect, this application provides another heat dissipation apparatus, including an evaporator, a condenser, and a first pipeline and a second pipeline that separately communicate with the evaporator and the condenser. The evaporator includes a housing. The housing has a sealed inner cavity. The housing is provided with a flow limiting groove. The flow limiting groove has an opening. A heat emitting element is fastened in the flow limiting groove. The second pipeline communicates with the flow limiting groove. A cooling working fluid in the condenser is transmitted to the flow limiting groove through the second pipeline. After dissipating heat for the heat emitting element, the cooling working fluid flows back to the condenser through the first pipeline for cooling.

According to the heat dissipation apparatus provided in the second aspect of this application, a circulation channel is also formed by the evaporator, the first pipeline, the condenser, and the second pipeline, so that the cooling working fluid circulates in the circulation channel. The cooling working fluid dissipates heat for the heat emitting element in the evaporator, is cooled in the condenser, and then returns to the evaporator.

According to the heat dissipation apparatus in this application, the flow limiting groove is further provided, to form a sealing structure with an opening on a periphery of the heat emitting element. When the second pipeline transmits the cooling working fluid to the flow limiting groove, the cooling working fluid is first in full contact with the heat emitting element for heat dissipation, and then flows into another area of the inner cavity through the opening. This ensures heat dissipation effect of the cooling working fluid for the heat emitting element.

In a possible implementation, a plurality of heat emitting elements are fastened in the housing. A flow limiting groove is provided outside each heat emitting element. A quantity of corresponding second pipelines is the same as a quantity of heat emitting elements. Each second pipeline communicates with one flow limiting groove.

In a possible implementation, the housing includes a front cover and a rear cover that are spaced from each other and fastened, and a flow limiting plate and a flow limiting wall that are connected between the front cover and the rear cover. The heat emitting element is located between the front cover and the rear cover, and is fastened to the front cover or the rear cover. The flow limiting plate is located at the bottom of the heat emitting element. Two flow limiting walls are located on two sides of the heat emitting element. The front cover, the rear cover, the flow limiting plate, and the flow limiting walls jointly enclose to form the flow limiting groove.

In this implementation, the flow limiting plate and the flow limiting walls are disposed to be separately connected between the front cover and the rear cover, so that a part of an area of the front cover and a part of an area of the rear cover can be used to jointly enclose to form the flow limiting groove with the flow limiting plate and the flow limiting walls, to form good wrapping effect for the heat emitting element.

In a possible implementation, the heat emitting element is fastened to an inner side wall of one of the front cover and the rear cover. The second pipeline communicates with an inner side wall of the other cover.

In this implementation, the heat emitting element is fastened to one side of the inner cavity, and the cooling working fluid enters the flow limiting groove from the other side, so that the cooling working fluid can be in full contact with the heat emitting element in the flow limiting groove. This ensures the heat dissipation effect of the cooling working fluid for the heat emitting element. In a possible implementation, the cooling working fluid in the condenser is transmitted to the flow limiting groove through the second pipeline under an action of gravity. After dissipating heat for the heat emitting element, the cooling working fluid flows into the first pipeline through the opening, and flows back to the condenser against a gravity direction for cooling.

In this implementation, the condenser is located above the evaporator in the gravity direction. When the cooling working fluid is transmitted to the inner cavity through the second pipeline under the action of gravity, the cooling working fluid may be in a liquid state. After dissipating heat for the heat emitting element, the cooling working fluid may be converted into gas, so that the cooling working fluid flows back to the condenser through the first pipeline against the gravity direction. In a possible implementation, the opening of the flow limiting groove faces upward against the gravity direction.

In this implementation, the opening of the flow limiting groove faces upward against the gravity direction, so that the heat emitting element can be soaked in the cooling working fluid in the flow limiting groove under the action of gravity, and the cooling working fluid with a low temperature that flows from the second pipeline can be in fuller contact with the heat emitting element. This improves a heat dissipation capability of the heat dissipation apparatus.

In a possible implementation, the housing further includes a plurality of support cradles spaced from each other. The plurality of support cradles are located in the inner cavity. Two opposite ends of each support cradle are respectively fastened to the front cover and the rear cover. The support cradles are configured to improve structural stability of the housing.

In a possible implementation, the heat emitting element is fastened to an inner side wall of one of the front cover and the rear cover. An inner side wall of the other cover is provided with a fitting area. A position of the fitting area is at least partially aligned with that of the heat emitting element. The fitting area is provided with a bump. The bump protrudes toward the heat emitting element and is in contact with the heat emitting element. The bump further has a pore. The pore is at least located on an end surface that is of the bump and that is in contact with the heat emitting element. In a possible implementation, there is a first distance between any two adjacent support cradles. The pore of the bump is formed by irregular arrangement of a plurality of holes. An inner diameter of any one of the holes is less than the first distance.

In a possible implementation, there is a first distance between any two adjacent support cradles. The bump includes a plurality of protruding portions spaced from each other. Gaps between the plurality of protruding portions form the pore. A distance between any two adjacent protruding portions is less than the first distance.

In a possible implementation, the housing is provided with a first communicating hole and a second communicating hole. The first pipeline communicates with the inner cavity through the first communicating hole. The second pipeline communicates with the inner cavity through the second communicating hole. The first communicating hole is located above the second communicating hole in the gravity direction.

In a possible implementation, the first communicating hole is located at the top of the housing in the gravity direction.

In a possible implementation, the heat dissipation apparatus includes a water pump. A pump port of the water pump communicates with the first pipeline and/or the second pipeline. The water pump is configured to drive circulation of the cooling working fluid.

In a possible implementation, the condenser is provided with a liquid inlet communicating with the first pipeline and a liquid outlet communicating with the second pipeline. The liquid inlet is located above the liquid outlet in the gravity direction.

According to a third aspect, this application provides still another heat dissipation apparatus, including an evaporator, a condenser, and a first pipeline and a second pipeline that separately communicate with the evaporator and the condenser. The evaporator includes a housing. The housing has a sealed inner cavity. The housing includes a front cover, a middle division plate, and a rear cover that are sequentially spaced from each other. The middle division plate divides the inner cavity into a front cavity close to the front cover and a rear cavity close to the rear cover. The first pipeline communicates with the front cavity. The second pipeline communicates with the rear cavity. The front cavity is provided with a flow limiting groove. A heat emitting element is fastened in the flow limiting groove. The flow limiting groove has an opening. A part of an area of the front cover and a part of an area of the middle division plate are further configured to form the flow limiting groove. The middle division plate is provided with a drainage hole communicating with the flow guiding groove and the rear cavity. A cooling working fluid in the condenser is transmitted to the rear cavity through the second pipeline. The cooling working fluid flows into the flow limiting groove through the drainage hole, and after dissipating heat for the heat emitting element, flows back to the condenser through the first pipeline for cooling.

According to the heat dissipation apparatus provided in the third aspect of this application, a circulation channel is also formed by the evaporator, the first pipeline, the condenser, and the second pipeline, so that the cooling working fluid circulates in the circulation channel. The cooling working fluid dissipates heat for the heat emitting element in the evaporator, is cooled in the condenser, and then returns to the evaporator.

According to the heat dissipation apparatus in this application, the middle division plate is further disposed, to limit a flow path of the cooling working fluid. When the cooling working fluid enters the front cavity from the rear cavity, because a flow guiding hole is located between the rear cavity and the flow limiting groove, it can be ensured that the cooling working fluid directly enters the flow limiting groove to dissipate heat for the heat emitting element, to ensure heat dissipation effect of the cooling working fluid for the heat emitting element.

In a possible implementation, the housing includes a flow limiting plate and a flow limiting wall that are connected between the front cover and the middle division plate. The heat emitting element is fastened to the front cover or the middle division plate. The flow limiting plate is located at the bottom of the heat emitting element. Two flow limiting walls are located on two sides of the heat emitting element. The front cover, the middle division plate, the flow limiting plate, and the flow limiting walls jointly enclose to form the flow limiting groove.

In a possible implementation, a plurality of heat emitting elements are fastened in the housing. A flow limiting groove is provided outside each heat emitting element. At least one drainage hole corresponding to each flow limiting groove is provided on the middle division plate.

In a possible implementation, the cooling working fluid in the condenser is transmitted to the flow limiting groove through the second pipeline under an action of gravity. After dissipating heat for the heat emitting element, the cooling working fluid flows into the first pipeline through the opening, and flows back to the condenser against a gravity direction for cooling.

In a possible implementation, the heat emitting element includes at least a first heat emitting element and a second heat emitting element. The first heat emitting element and the second heat emitting element are spaced from each other and fastened. In a direction perpendicular to a direction in which the first heat emitting element and the second heat emitting element are spaced from each other, the first heat emitting element and the second heat emitting element form, on an inner surface of the housing, two projection areas spaced from each other. The second pipeline has a second communicating hole communicating with the housing. The second communicating hole and the two projection areas are located on the same inner surface of the housing, and the second communicating hole is located between the two projection areas.

In this implementation, the second pipeline communicates with the rear cavity through the second communicating hole, and the second communicating hole is located between the projection areas formed by the first heat emitting element and the second heat emitting element. The cooling working fluid that enters the rear cavity from the second communicating hole may flow in two opposite directions, and then enter, from two different drainage holes, flow limiting grooves respectively corresponding to the first heat emitting element and the second heat emitting element, to form heat dissipation effect for both the first heat emitting element and the second heat emitting element. This ensures evenness of heat dissipation.

In a possible implementation, the first heat emitting element is located above the second heat emitting element in the gravity direction. The housing further includes two opposite side plates. The two opposite side plates are respectively arranged on two sides of the front cover and are separately connected between the front cover and the rear cover. There are two second pipelines. Each second pipeline is connected to one side plate.

In a possible implementation, there are a plurality of drainage holes. The plurality of drainage holes are spaced from each other in a length direction of the flow limiting plate and/or a length direction of the flow limiting wall.

In a possible implementation, the drainage holes are strip-shaped. The strip-shaped drainage holes extend in a length direction of the flow limiting plate and/or a length direction of the flow limiting wall.

In a possible implementation, the drainage holes are strip-shaped. The strip-shaped drainage holes extend in both a length direction of the flow limiting wall and a length direction of the flow limiting wall, and the strip-shaped drainage holes sequentially communicate with each other.

In the foregoing implementations, different structures of the drainage holes may increase areas of the drainage holes, so that more cooling working fluids flow into the flow limiting groove to dissipate heat for the heat emitting element.

In a possible implementation, the housing further includes a plurality of support cradles spaced from each other. The plurality of support cradles are located in the inner cavity. Two opposite ends of each support cradle are respectively fastened to the front cover and the middle division plate. The support cradles are configured to improve structural stability of the housing.

In a possible implementation, the heat emitting element is fastened to an inner side wall of one of the front cover and the middle division plate. An inner side wall of the other cover is provided with a fitting area. A position of the fitting area is at least partially aligned with that of the heat emitting element. The fitting area is provided with a bump. The bump protrudes toward the heat emitting element and is in contact with the heat emitting element. The bump further has a pore. The pore is at least located on an end surface that is of the bump and that is in contact with the heat emitting element.

In a possible implementation, there is a first distance between any two adjacent support cradles. The pore of the bump is formed by irregular arrangement of a plurality of holes. An inner diameter of any one of the holes is less than the first distance.

In a possible implementation, there is a first distance between any two adjacent support cradles. The bump includes a plurality of protruding portions spaced from each other. Gaps between the plurality of protruding portions form the pore. A distance between any two adjacent protruding portions is less than the first distance.

In a possible implementation, the housing is provided with a first communicating hole and a second communicating hole. The first pipeline communicates with the inner cavity through the first communicating hole. The second pipeline communicates with the inner cavity through the second communicating hole. The first communicating hole is located above the second communicating hole in the gravity direction.

In a possible implementation, the first communicating hole is located at the top of the housing in the gravity direction.

In a possible implementation, the heat dissipation apparatus includes a water pump. A pump port of the water pump communicates with the first pipeline and/or the second pipeline. The water pump is configured to drive circulation of the cooling working fluid.

In a possible implementation, the condenser is provided with a liquid inlet communicating with the first pipeline and a liquid outlet communicating with the second pipeline. The liquid inlet is located above the liquid outlet in the gravity direction.

According to a fourth aspect, this application provides yet another heat dissipation apparatus, including an evaporator, a condenser, and a first pipeline and a second pipeline that separately communicate with the evaporator and the condenser. The evaporator includes a housing. The housing has a sealed inner cavity. The housing further includes a front cover and a rear cover that are spaced from each other and fastened. A heat emitting element is fastened to an inner side wall of one of the front cover and the rear cover. An inner side wall of the other cover is provided with a fitting area. A position of the fitting area is at least partially aligned with that of the heat emitting element. The fitting area is provided with a bump. The bump protrudes toward the heat emitting element and is in contact with the heat emitting element. The bump further has a pore. The pore is at least located on an end surface that is of the bump and that is in contact with the heat emitting element. A cooling working fluid in the condenser is transmitted to the inner cavity through the second pipeline. The cooling working fluid flows back to the condenser through the first pipeline for cooling. A part of the cooling working fluid dissipates heat for the heat emitting element at the pore of the bump.

According to the heat dissipation apparatus provided in the fourth aspect of this application, a circulation channel is also formed by the evaporator, the first pipeline, the condenser, and the second pipeline, so that the cooling working fluid circulates in the circulation channel. The cooling working fluid dissipates heat for the heat emitting element in the evaporator, is cooled in the condenser, and then returns to the evaporator.

In the heat dissipation apparatus in this application, the bump on the fitting area is provided, so that the pore of the bump abuts against and is in contact with the heat emitting element, and the cooling working fluid can form more nucleation points on a surface of the heat emitting element. This improves heat dissipation effect of the cooling working fluid for the heat emitting element. In a possible implementation, the housing further includes a plurality of support cradles spaced from each other. The plurality of support cradles are located in the inner cavity. Two opposite ends of each support cradle are respectively fastened to the front cover and the rear cover. The support cradles are configured to improve structural stability of the housing.

In a possible implementation, there is a first distance between any two adjacent support cradles. The pore of the bump is formed by irregular arrangement of a plurality of holes. An inner diameter of any one of the holes is less than the first distance.

In a possible implementation, there is a first distance between any two adjacent support cradles.

The bump includes a plurality of protruding portions spaced from each other. Gaps between the plurality of protruding portions form the pore. A distance between any two adjacent protruding portions is less than the first distance.

In a possible implementation, the cooling working fluid in the condenser is transmitted to the inner cavity through the second pipeline under an action of gravity. After dissipating heat for the heat emitting element, the cooling working fluid flows back to the condenser through the first pipeline against a gravity direction for cooling.

In a possible implementation, the housing is provided with a first communicating hole and a second communicating hole. The first pipeline communicates with the inner cavity through the first communicating hole. The second pipeline communicates with the inner cavity through the second communicating hole. The first communicating hole is located above the second communicating hole in the gravity direction.

In a possible implementation, the first communicating hole is located at the top of the housing in the gravity direction.

In a possible implementation, the heat dissipation apparatus includes a water pump. A pump port of the water pump communicates with the first pipeline and/or the second pipeline. The water pump is configured to drive circulation of the cooling working fluid.

In a possible implementation, the condenser is located above the evaporator, and the condenser is provided with a liquid inlet communicating with the first pipeline and a liquid outlet communicating with the second pipeline. The liquid inlet is located above the liquid outlet in the gravity direction.

According to a fifth aspect, this application provides a power converter, including a power semiconductor device and the heat dissipation apparatus according to any one of the first aspect to fourth aspect. The power semiconductor device is fastened in an inner cavity of the heat dissipation apparatus as a heat emitting element. The heat dissipation apparatus is configured to dissipate heat for the power semiconductor device.

It may be understood that the power converter provided in this application implements a power conversion function by using the power semiconductor device. The power semiconductor device, namely, the heat emitting element, cooperates with the heat dissipation apparatus according to any one of the first aspect to the fourth aspect of this application, to improve heat dissipation effect for the power semiconductor device. This ensures reliable working of the power converter in this application.

### BRIEF DESCRIPTION OF DRAWINGS

FIG. 1 is a diagram of a framework structure of an inverter according to an embodiment of this application;
FIG. 2a is a diagram of a structure of a heat dissipation apparatus according to an embodiment of this application;
FIG. 2b is a diagram of a structure of another implementation of a heat dissipation apparatus according to an embodiment of this application;
FIG. 2c is a diagram of a structure of still another implementation of a heat dissipation apparatus according to an embodiment of this application;
FIG. 3 is a diagram of an internal structure of a housing in a heat dissipation apparatus according to an embodiment of this application;
FIG. 4 is a diagram of a structure of a heat dissipation apparatus in a conventional technology;
FIG. 5 is a diagram of a structure of another embodiment of a heat dissipation apparatus according to an embodiment of this application;
FIG. 6 is a diagram of a structure of a front cover in a heat dissipation apparatus according to an embodiment of this application;
FIG. 7 is a diagram of a structure of a cross section of a heat dissipation apparatus according to an embodiment of this application;
FIG. 8a is a diagram of a pore structure of a front cover in a heat dissipation apparatus according to an embodiment of this application;
FIG. 8b is a diagram of another pore structure of a front cover in a heat dissipation apparatus according to an embodiment of this application;
FIG. 8c is a diagram of still another pore structure of a front cover in a heat dissipation apparatus according to an embodiment of this application;
FIG. 9 is a diagram of a structure of another heat dissipation apparatus according to an embodiment of this application;
FIG. 10 is a diagram of a structure of a cross section of another heat dissipation apparatus according to an embodiment of this application;
FIG. 11 is a diagram of a structure of still another heat dissipation apparatus according to an embodiment of this application;
FIG. 12 is a diagram of a structure of a cross section of still another heat dissipation apparatus according to an embodiment of this application;
FIG. 13 is a diagram of a structure of a middle division plate in still another heat dissipation apparatus according to an embodiment of this application;
FIG. 14 is a diagram of a structure of another side of a middle division plate in still another heat dissipation apparatus according to an embodiment of this application;
FIG. 15a is a diagram of a partial structure of a flow limiting groove in a heat dissipation apparatus according to an embodiment of this application;
FIG. 15b is a diagram of another partial structure of a flow limiting groove in a heat dissipation apparatus according to an embodiment of this application;
FIG. 16 is a diagram of a structure of yet another heat dissipation apparatus according to an embodiment of this application;
FIG. 17 is a diagram of a structure of a front cover in yet another heat dissipation apparatus according to an embodiment of this application;
FIG. 18 is a diagram of a structure of a cross section of yet another heat dissipation apparatus according to an embodiment of this application;
FIG. 19a is a diagram of a pore structure of a front cover in yet another heat dissipation apparatus according to an embodiment of this application;
FIG. 19b is a diagram of another pore structure of a front cover in yet another heat dissipation apparatus according to an embodiment of this application; and
FIG. 19c is a diagram of still another pore structure of a front cover in yet another heat dissipation apparatus according to an embodiment of this application.

### DESCRIPTION OF EMBODIMENTS

The following describes technical solutions in embodiments of this application with reference to accompanying drawings in embodiments of this application. It is clear that the described embodiments are merely some but not all of embodiments of this application. All other embodiments obtained by a person of ordinary skill in the art based on embodiments of this application without creative efforts shall fall within the protection scope of this application.

The power converter provided in this application may be a device, for example, an inverter, a motor driver, or an uninterruptible power supply. A power semiconductor device is disposed in the power converter, and may be used as a controllable switch in the power converter, to implement a power conversion function. A component, for example, a capacitor, an inductor, or a resistor, may be further disposed in the power converter, and is configured to cooperate with the power semiconductor device, to form an inverter circuit or a boost circuit.

To clearly present features of the power converter in this application, an inverter is used as an example in subsequent embodiments to describe the power converter and an inverter circuit included in the power converter. It may be understood that a similar power converter may also be used as a device, for example, a motor driver or an uninterruptible power supply.

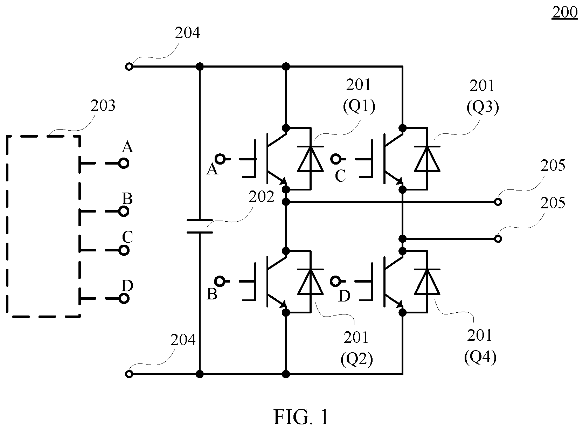

FIG. 1 is a diagram of a framework structure of an inverter 200 according to this application.

In FIG. 1, an inverter circuit of the inverter 200 includes two input ends 204 and two output ends 205. Four power semiconductor devices 201, one controller 203, and one capacitor 202 are disposed between the input ends 204 and the output ends 205. The controller 203 is configured to control turn-on and turn-off of each power semiconductor device 201. The four power semiconductor devices 201 are respectively defined as switches Q1 to Q4, and form two bridge arms, and each bridge arm includes two power semiconductor devices 201 connected in series between a positive electrode and a negative electrode of the inverter circuit. The capacitor 202 is connected between a positive electrode and a negative electrode of the input ends 204, and is configured to filter voltages and currents in the input ends 204 of the inverter circuit.

In the inverter circuit shown in FIG. 1, the four power semiconductor devices 201 are also used as controllable switches through control by the controller 203, and on and off states of the four power semiconductor devices 201 in the two bridge arms are controlled, to form two different conductive paths.

Specifically, the controller 203 has four control ports A, B, C, and D for respectively and correspondingly controlling turn-on and turn-off of the four power semiconductor devices 201: Q1, Q2, Q3, and Q4. When the switches Q1 and Q4 are in the on state, and the switches Q2 and Q3 are in the off state, positive phase transmission is performed between the positive electrode and the negative electrode of the inverter circuit. When the switches Q2 and Q3 are in the on state, and the switches Q1 and Q4 are in the off state, negative phase transmission is performed between the positive electrode and the negative electrode of the inverter circuit. Voltages obtained by the output ends 205 in the two states have opposite polarities.

In this way, the inverter circuit shown in FIG. 1 implements an inversion function. The inverter circuit may implement direct current-alternating current conversion or alternating current-direct current conversion, to implement a power conversion function. It may be understood that, in some embodiments, when an alternating current is a three-phase alternating current, six power semiconductor devices 201 may be disposed, and every two power semiconductor devices 201 are configured to implement a power conversion function on one alternating current, to form power conversion of the three-phase alternating current.

The power semiconductor device 201 is usually configured for power conversion of a high voltage and a high current, and generates large heat in a long-term working process. Therefore, a heat dissipation apparatus is further disposed in the inverter 200, and is configured to dissipate heat for the power semiconductor device 201, to ensure normal working of the power semiconductor device 201.

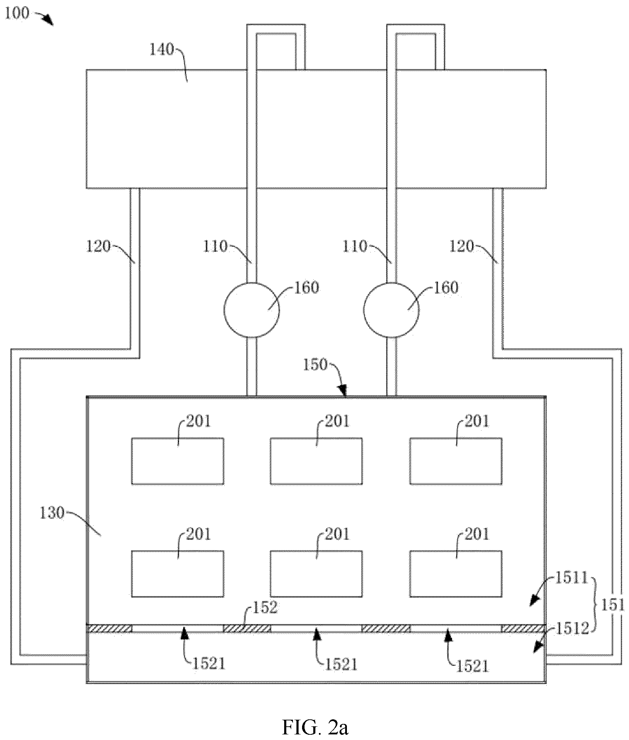

Specifically, FIG. 2a is a diagram of a structure of a heat dissipation apparatus 100 according to this application.

In the embodiment shown in FIG. 2a, the heat dissipation apparatus 100 includes a first pipeline 110, a second pipeline 120, an evaporator 130, and a condenser 140. The first pipeline 110 communicates with the evaporator 130 and the condenser 140, the second pipeline 120 also communicates with the evaporator 130 and the condenser 140, and the first pipeline 110 and the second pipeline 120 are independent of each other. In this way, the heat dissipation apparatus 100 can form a circulation path of "the evaporator 130-the first pipeline 110-the condenser 140-the second pipeline 120-the evaporator 130".

A cooling working fluid is injected into the heat dissipation apparatus 100, and the cooling working fluid may circulate on the circulation path. The evaporator 130 includes a housing 150, and a heat emitting element 201 is fastened in the housing 150. The cooling working fluid is configured to form heat exchange with the heat emitting element 201 in the housing 150. After a temperature of the cooling working fluid increases, the cooling working fluid may flow from the first pipeline 110 to the condenser 140. The condenser 140 is configured to cool the cooling working fluid. The cooled cooling working fluid flows back to the evaporator 130 through the second pipeline 120, and forms heat exchange with the heat emitting element 201 again. Heat dissipation effect of the heat dissipation apparatus 100 in this application for the heat emitting element 201 is formed through circulation.

It may be understood that, in this embodiment, the heat emitting element 201 may correspond to the power semiconductor device 201 in the inverter 200. In addition, in FIG. 2a, there are six power semiconductor devices 201, and the inverter 200 may be configured for power conversion of a three-phase alternating current. The power semiconductor device 201 has a high temperature in a working process, and the cooling working fluid in the heat dissipation apparatus 100 in this application may be water or a coolant. After forming heat exchange with the power semiconductor 201, the cooling working fluid may evaporate and vaporize, and is in a gas-liquid two-phase mixing state at the top of the housing 150. In some other embodiments, the cooling working fluid in the heat dissipation apparatus 100 may alternatively be in a form of pure gas or pure liquid. This does not affect function implementation of the heat dissipation apparatus 100.

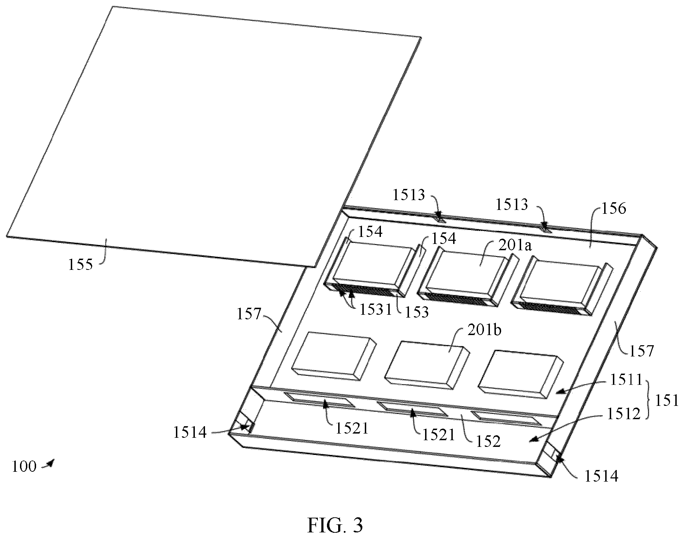

FIG. 3 shows a specific internal structure of the housing 150.

In the heat dissipation apparatus 100 provided in this embodiment, the housing 150 has a sealed inner cavity 151, and the evaporator 130 further includes a division plate 152. The division plate 152 is located in the inner cavity 151, and is configured to divide the inner cavity 151 into a first sub-cavity 1511 and a second sub-cavity 1512. In FIG. 2a and FIG. 3, the first sub-cavity 1511 is located above the second sub-cavity 1512 in a gravity direction. In addition, the housing 150 is configured as a cuboid, and the division plate 152 is arranged in a horizontal direction, so that the first sub-cavity 1511 and the second sub-cavity 1512 each are also rectangular cavities. In some other embodiments, the division plate 152 may alternatively be obliquely fastened in the inner cavity 151, so that the first sub-cavity 1511 and the second sub-cavity 1512 each are right-angle trapezoidal cavities. This does not affect function implementation of the heat dissipation apparatus 100 in this application.

Still refer to FIG. 3. In this embodiment, the plurality of power semiconductor devices 201 are all fastened in the first sub-cavity 1511. The first pipeline 110 communicates with the first sub-cavity 1511. The second pipeline 120 communicates with the second sub-cavity 1512. The division plate 152 is further provided with a flow guiding hole 1521. The flow guiding hole 1521 is configured for the first sub-cavity 1511 to communicate with the second sub-cavity 1512. Based on the foregoing descriptions of the circulation path of the cooling working fluid, the cooling working fluid cooled by the condenser 140 first flows into the lower second sub-cavity 1512 through the second pipeline 120. Then, the cooling working fluid may pass through the flow guiding hole 1521, and then enter the first sub-cavity 1511, to form heat exchange with the power semiconductor device 201.

For the heat dissipation apparatus 100 in this embodiment, the flow guiding hole 1521 in the division plate 152 needs to be provided corresponding to a position of the power semiconductor device 201, the flow guiding hole 1521 is located below the power semiconductor device 201, and at least a part of the flow guiding hole 1521 directly faces the power semiconductor device 201 located in the first sub-cavity 1511. The so-called "facing" is described with reference to a flow direction of the cooling working fluid in which the cooling working fluid flows from the flow guiding hole 1521 to the first sub-cavity 1511, to dissipate heat for the power semiconductor device 201 corresponding to the flow guiding hole 1521. In the embodiment shown in the figure, the flow guiding hole 1521 may alternatively be provided completely and directly facing the power semiconductor device 201. In other words, the flow guiding hole 1521 is located right below the power semiconductor device 201.

Therefore, in this embodiment, there are three flow guiding holes 1521, and one flow guiding hole 1521 is provided below each power semiconductor device 201. The cooling working fluid with a low temperature that flows from the second sub-cavity 1512 to the first sub-cavity 1511 may reach the power semiconductor device 201 through a short flow path, and form heat exchange with the power semiconductor device 201.

It may be understood that, at a position in which the power semiconductor device 201 is not disposed, the cooling working fluid cannot enter the first sub-cavity 1511 due to a blocking function of the division plate 152. The cooling working fluid enters the first sub-cavity 1511 only through the flow guiding hole 1521. A flow path of the cooling working fluid is short in a process for reaching the power semiconductor 201, and heat exchange performed by the cooling working fluid in the first sub-cavity 1511 with a high temperature is also reduced. This ensures that the temperature of the cooling working fluid is low when the cooling working fluid exchanges heat with the power semiconductor device 201, and therefore improves the heat dissipation effect of the heat dissipation apparatus 100 in this application for the power semiconductor device 201.

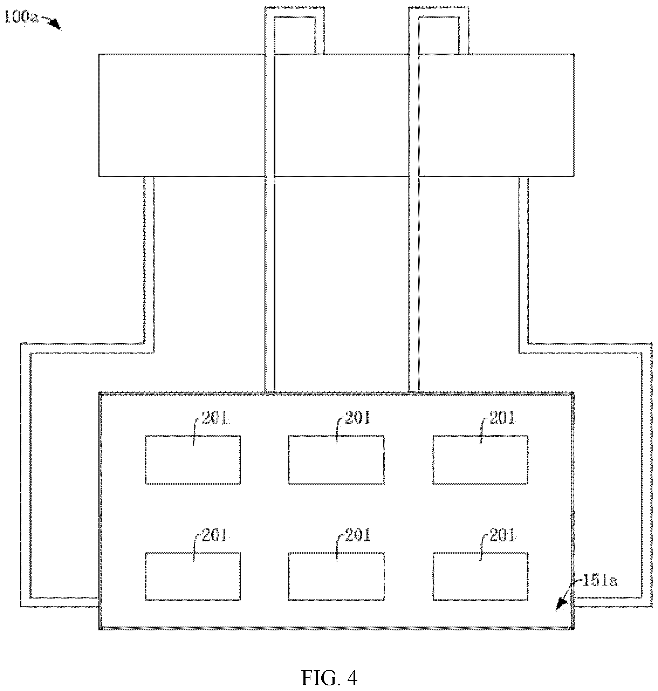

FIG. 4 shows a structure of a heat dissipation apparatus 100a in a conventional technology.

In the heat dissipation apparatus 100a in the conventional technology shown in FIG. 4, a flow channel of a cooling working fluid is not limited in an inner cavity 151a. After the cooling working fluid enters the inner cavity 151a, a path for the cooling working fluid to flow to a power semiconductor device 201 is long. Consequently, the cooling working fluid reaches the power semiconductor device 201 with a high temperature as the cooling working fluid has performed heat exchange in the inner cavity 151a for a long time. Consequently, the heat dissipation apparatus 100a in the conventional technology has low efficiency and limited effect of heat dissipation for the power semiconductor device 201.

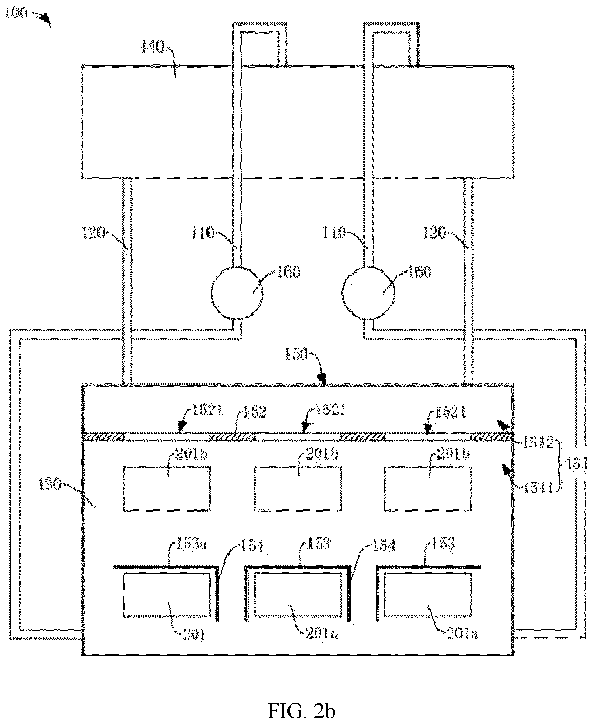

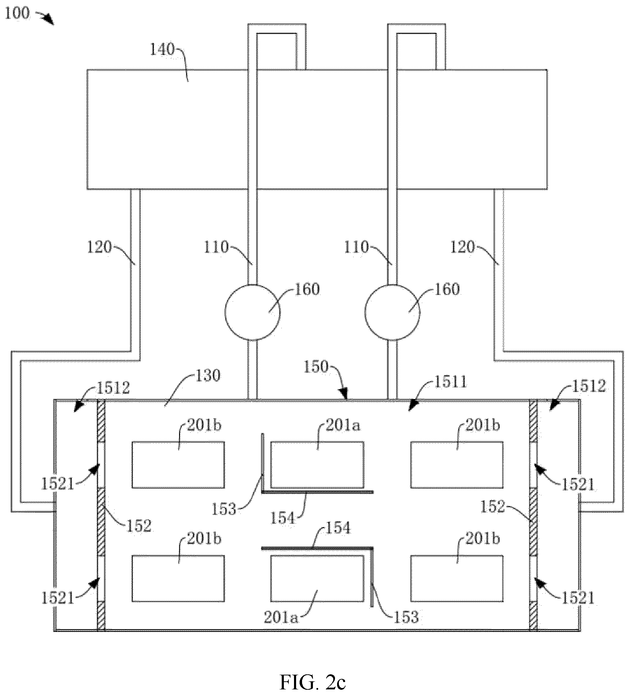

FIG. 2b and FIG. 2c are diagrams of another two structures of the heat dissipation apparatus 100 according to this application.

In FIG. 2b, the first sub-cavity 1511 is located below the second sub-cavity 1512 in the gravity direction, and the flow guiding hole 1521 in the division plate 152 is located above each power semiconductor device 201. At least a part of the flow guiding hole 1521 is provided directly facing the power semiconductor device 201 in the first sub-cavity 1511. In this case, the second pipeline 120 transmits the cooling working fluid to an upper part of the inner cavity 151 (the second sub-cavity 1512), and the cooling working fluid flows from the flow guiding hole 1521 to the power semiconductor device 201 under an action of gravity. Due to a function of the division plate 152, when the cooling working fluid flows from the second sub-cavity 1512 to the power semiconductor device 201, a flow path of the cooling working fluid is also short. Therefore, beneficial effects similar to those of the heat dissipation apparatus 100 shown in FIG. 2a can also be achieved.

In FIG. 2c, there are two division plates 152. The two division plates 152 form one second sub-cavity 1512 on each of two opposite sides of the inner cavity 151, and form one first sub-cavity 1511 at a middle part of the inner cavity 151. In other words, in this embodiment, the two second sub-cavities 1512 are respectively located on two opposite sides of the first sub-cavity 1511. In this case, at least a part of the flow guiding hole 1521 in the division plate 152 is provided directly facing the power semiconductor device 201 from a side. Second pipelines 120 separately transmit the cooling working fluid to the second sub-cavities 1512 on the two sides of the inner cavity 151, and the cooling working fluid flows from the flow guiding hole 1521 to the power semiconductor device 201 under an action of pressure. Due to a function of the division plate 152, when the cooling working fluid flows from the second sub-cavity 1512 to the power semiconductor device 201, a flow path of the cooling working fluid is also short. Therefore, beneficial effects similar to those of the heat dissipation apparatus 100 shown in FIG. 2a and those of the heat dissipation apparatus 100 shown in FIG. 2b can also be achieved.

Therefore, according to the heat dissipation apparatus 100 provided in this embodiment, in a process of dividing the inner cavity 151 into the first sub-cavity 1511 and the second sub-cavity 1512 by using the division plate 152, relative positions of the first sub-cavity 1511 and the second sub-cavity 1512 are not strictly limited, provided that at least a part of the flow guiding hole 1521 in the division plate 152 is provided directly facing the power semiconductor device 201. In this way, it can be ensured that the cooling working fluid reaches the power semiconductor device 201 through a short flow path. This improves the heat dissipation effect of the heat dissipation apparatus 100.

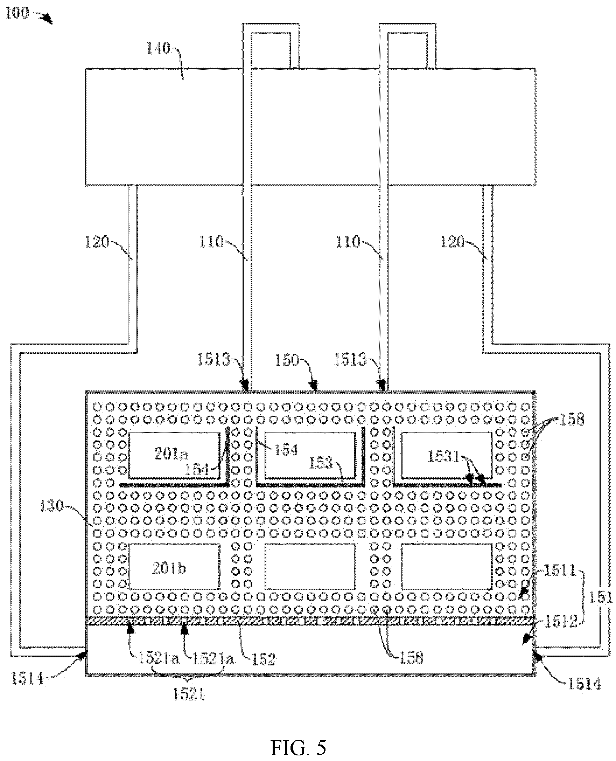

Refer to FIG. 5. In an embodiment, the plurality of power semiconductor devices 201 may be arranged in an array in the inner cavity 151. In this embodiment, the plurality of power semiconductor devices 201 may include first power semiconductor devices 201a and second power semiconductor devices 201b. The first power semiconductor device 201a is located above the second power semiconductor device 201b in the gravity direction. The housing 150 is further provided with a flow limiting plate 153. The flow limiting plate 153 is located between the first power semiconductor device 201a and the second power semiconductor device 201b, and is configured to guide the cooling working fluid flowing from the second power semiconductor device 201b to the first power semiconductor device 201a.

It may be understood that, corresponding to the embodiment of FIG. 2b or FIG. 2c, when the flow direction of the cooling working fluid is different from a flow direction of the cooling working fluid shown in FIG. 5, the second power semiconductor device 201b may be located between the first power semiconductor device 201 and the division plate 152, and the flow limiting plate 153 is located between the first power semiconductor device 201a and the second power semiconductor device 201b. This can also guide the cooling working fluid flowing from the second power semiconductor device 201b to the first power semiconductor device 201a.

Specifically, still refer to FIG. 5. After entering the first sub-cavity 1511 from the lower second sub-cavity 1512, the cooling working fluid is first in contact with the lower second power semiconductor device 201b, and after exchanging heat with the second power semiconductor device 201b, the cooling working fluid flows upward to the first power semiconductor device 201a against the gravity direction, to form heat exchange with the first power semiconductor device 201a. In this way, the cooling working fluid also flows toward the top of the inner cavity 151 in a temperature increasing process. Correspondingly, when exchanging heat with the power semiconductor 201, a part of the cooling working fluid in a liquid state may further generate a bubble. The bubble also flows toward the top of the inner cavity 151.

For the heat dissipation apparatus 100 in this embodiment, if the cooling working fluid generates the bubble when exchanging heat with the second power semiconductor device 201b, the bubble continues to flow upward in the flow direction of the cooling working fluid, and may be in contact with the first power semiconductor device 201a. More bubbles in contact with the first power semiconductor device 201a indicate fewer cooling working fluids for forming heat exchange with the first power semiconductor device 201a. In other words, more bubbles flowing to the first power semiconductor device 201a indicate poorer heat dissipation effect of the cooling working fluid for the first power semiconductor device 201a.

In FIG. 5, the flow limiting plate 153 provided in this embodiment is further provided with penetrated apertures 1531. There are a plurality of apertures 1531, and the plurality of apertures 1531 are spaced from each other in the flow limiting plate 153. A width of the aperture 1531 is narrow, and may be configured to block the bubble flowing from the second power semiconductor device 201b to the first power semiconductor device 201a. It may be understood that, when a size of the bubble is large, because the bubble cannot pass through the narrow aperture 1531, the bubble may break out, or flow in a direction of the flow limiting plate 153, cross from a side of the flow limiting plate 153, and continue to flow upward in the flow direction of the cooling working fluid. The cooling working fluid in the liquid state may pass through the apertures 1531 and flow to the first power semiconductor device 201a located above the flow limiting plate 153.

In this way, under an action of the flow limiting plate 153, the first power semiconductor device 201a is prevented from being in excessive contact with the bubble, but is in contact with the cooling working fluid in the liquid state. This improves the heat dissipation effect of the heat dissipation apparatus 100 in this application for the first power semiconductor device 201a.

It may be understood that, corresponding to the embodiment of FIG. 2b, the flow limiting plate 153 is located between the first power semiconductor device 201a and the second power semiconductor device 201b. Because the first power semiconductor device 201a in FIG. 2b is located below the second power semiconductor device 201b in a vertical direction, the flow limiting plate 153 is configured to guide the cooling working fluid flowing in the gravity direction. In the embodiment of FIG. 2b, the flow limiting plate 153 may also be provided with apertures 1531 (not shown in FIG. 2b) for blocking a bubble. When the cooling working fluid exchanges heat with the upper second power semiconductor device 201b, a bubble may be formed, and the bubble may continue to flow downward to the first power semiconductor device 201a with the cooling working fluid. When the cooling working fluid exchanges heat with the lower first power semiconductor device 201a, a bubble may also be formed, and the bubble may flow toward the upper second power semiconductor 201b against the gravity direction due to a light weight. In this way, the flow limiting plate 153 can block bubbles in two opposite directions, to ensure reliable heat dissipation effect for both the first power semiconductor device 201a and the second power semiconductor device 201b.

Corresponding to the embodiment of FIG. 2c, the flow limiting plate 153 may be located between the first power semiconductor device 201a and the second power semiconductor device 201b in the horizontal direction. Among three power semiconductor devices 201 located at a same horizontal height, one power semiconductor device 201 located in the middle is the first power semiconductor device 201a, and two power semiconductor devices 201 located on two sides are both second power semiconductor devices 201b. The cooling working fluid flows from the two sides of the inner cavity 151 to the middle, and the flow limiting plate 153 can guide the cooling working fluid flowing from the two sides to the first power semiconductor device 201a. Further, when the flow limiting plate 153 is provided with the apertures 1531 (not shown in FIG. 2c), the bubble can also be prevented from flowing to the first power semiconductor device 201a.

As mentioned above, when being blocked by the flow limiting plate 153, the bubble passes through the side of the flow limiting plate 153, and continues to flow with the cooling working fluid. In an embodiment, the housing 150 is further provided with a flow limiting wall 154. The flow limiting wall 154 is located on a side of the first power semiconductor device 201a, and is configured to prevent the bubble from being in contact with the side of the first power semiconductor device 201a. This further improves the heat dissipation effect for the first power semiconductor device 201a.

Specifically, as shown in FIG. 5, there may be one flow limiting wall 154. The flow limiting wall 154 is located on one side of the first power semiconductor device 201a, and the flow limiting wall 154 is fastened to the flow limiting plate 153, and is configured to prevent a bubble on one side from being in contact with the side of the first power semiconductor device 201a. When there is one flow limiting wall 154, the flow limiting wall 154 may alternatively be located between two first power semiconductor devices 201a. Because the power semiconductor devices 201 are arranged in an array, when two first power semiconductor devices 201a are arranged in parallel, another two second power semiconductor devices 201b are also arranged in parallel below the two first power semiconductor devices 201a. The two lower second power semiconductor devices 201b work together, and may generate more bubbles. Therefore, disposing the flow limiting wall 154 between the two first power semiconductor devices 201a can better block the bubble.

In another embodiment, there may alternatively be two flow limiting walls 154. The two flow limiting walls 154 are respectively arranged on two opposite sides of the first power semiconductor device 201a, and the two flow limiting walls 154 are respectively fastened to two opposite ends of the flow limiting plate 153. In this case, the two flow limiting walls 154 may respectively block bubbles for the two opposite sides of the first power semiconductor device 201a, to ensure that the first power semiconductor device 201a is in more contact with and exchanges heat with the cooling working fluid in the liquid state. This improves the heat dissipation effect of the heat dissipation apparatus 100 in this application.

In an embodiment, the flow limiting wall 154 may also be provided with an aperture structure (not shown in the figure). The aperture structure may block the bubble and allow the cooling working fluid in the liquid state to pass through. This achieves better heat dissipation effect for the first power semiconductor device 201a.

In the structure shown in FIG. 2b, because the first power semiconductor device 201a is located below the second power semiconductor device 201b in the gravity direction, the flow limiting wall 154 also extends downward in the gravity direction. In the structure shown in FIG. 2c, the flow limiting wall 154 extends toward the first power semiconductor device 201a in the horizontal direction. Because the flow limiting plate 153 is disposed on both sides of the first power semiconductor device 201a, in FIG. 2c, the flow limiting wall 154 may extend from only the flow limiting plate 153 on one side to the first power semiconductor device 201a.

Refer back to FIG. 3. The housing 150 includes a front cover 155, a rear cover 156, and side plates 157. The front cover 155 and the rear cover 156 are spaced from each other and fastened, and the side plates 157 are fastened between the front cover 155 and the rear cover 156. There are two side plates 157, and the two side plates 157 are respectively arranged on two opposite sides of the housing 150. In an embodiment, the flow limiting plate 153 is fastened to both the front cover 155 and the rear cover 156. In this way, the flow limiting plate 153 better blocks the bubble, to prevent the bubble from passing through a clearance between the flow limiting plate 153 and the front cover 155 or a clearance between the flow limiting plate 153 and the rear cover 156 and being in contact with the first power semiconductor device 201a.

In some other embodiments, the flow limiting wall 154 may alternatively be fastened to both the front cover 155 and the rear cover 156. A function of the flow limiting wall 154 is similar to a function of the flow limiting plate 153. The flow limiting wall 154 can also prevent the bubble from passing through a clearance. This ensures the heat dissipation effect for the first power semiconductor device 201a.

In an embodiment, the flow guiding hole 1521 may further include a plurality of flow guiding sub-holes 1521a (refer to FIG. 5). In other words, the flow guiding hole 1521 is formed by the plurality of flow guiding sub-holes 1521a spaced from each other. The plurality of flow guiding sub-holes 1521a are provided, so that the cooling working fluid can flow into the first sub-cavity 1511 evenly, and form better heat dissipation effect for the power semiconductor device 201.

In addition, the cooling working fluid may also generate a bubble during flowing. Alternatively, when the cooling working fluid flowing out of the condenser 140 is also in a gas-liquid two-phase state, the cooling working fluid flowing into the second sub-cavity 1512 may also have a bubble. The plurality of flow guiding sub-holes 1521a are provided, so that the bubble in the second sub-cavity 1512 can also be blocked, to prevent the bubble from entering the first sub-cavity 1511 through the flow guiding hole 1521 and being in contact with the second power semiconductor device 201b, to affect the heat dissipation effect of the heat dissipation apparatus 100 for the second power semiconductor device 201b.

In FIG. 5, the housing 150 further includes a plurality of support cradles 158 spaced from each other. The plurality of support cradles 158 are located in the inner cavity 151. Two opposite ends of each support cradle 158 are respectively fastened to the front cover 155 and the rear cover 156, to improve overall structural stability of the housing 150. In a working process of the heat dissipation apparatus 100 in this application, the inner cavity 151 is always in a high temperature state. The housing 150 may be deformed when being in a high temperature environment for a long time. The support cradles 158 may be disposed to separately fasten the front cover 155 and the rear cover 156, to prevent the housing 150 from being deformed. The support cradles 158 may be integrated with the front cover 155 or the rear cover 156, or the support cradles 158 may be fastened to the front cover 155 or the rear cover 156 through welding or the like.

In addition, the support cradles 158 are arranged in the inner cavity 151, and may further form specific guiding effect for the cooling working fluid. Specifically, when the cooling working fluid flows through each support cradle 158, drainage effect and distribution effect are formed, so that the cooling working fluid flows more evenly and fully in the inner cavity 151, and temperature distribution in the inner cavity 151 is more balanced. This improves the heat dissipation effect of the heat dissipation apparatus 100 in this application.

In an embodiment, the housing 150 is provided with a first communicating hole 1513 and a second communicating hole 1514 (refer to FIG. 3). The first pipeline 110 communicates with the inner cavity 151 through the first communicating hole 1513. The second pipeline 120 communicates with the inner cavity 151 through the second communicating hole 1514. In an embodiment, the first communicating hole 1513 is located above the second communicating hole 1514 in the gravity direction. For example, in the heat dissipation apparatus 100 shown in FIG. 5, the first communicating hole 1513 is located in the first sub-cavity 1511, and the second communicating hole 1514 is located in the second sub-cavity 1512. The first sub-cavity 1511 is located above the second sub-cavity 1512 in the gravity direction. In this case, the first communicating hole 1513 is also located above the second communicating hole 1514 in the gravity direction.

Because the cooling working fluid with a high temperature in the inner cavity 151 flows upward, and the bubble also flows upward, the cooling working fluid in a high-temperature gas state is mostly gathered at the top of the inner cavity 151. When the first communicating hole 1513 is located at an upper position of the inner cavity 151, the cooling working fluid with a high temperature (in a gas state or a gas-liquid mixing state) may flow to the condenser 140 through the first pipeline 110. In other words, the condenser 140 may cool the cooling working fluid with a high temperature. When the second communicating hole 1514 is located at a lower position of the inner cavity 151, the cooling working fluid with a low temperature may enter the inner cavity 151 from the lower position, and flow upward in the inner cavity 151, to implement better cooling effect.

In an embodiment, the first communicating hole 1513 is further located at the top of the housing 150 in the gravity direction. In an embodiment, there may be two first communicating holes 1513, and correspondingly, there are also two first pipelines 110. The two first communicating holes 1513 are spaced from each other, to evenly send the cooling working fluid back to the condenser 140 from the top of the inner cavity 151.

In an embodiment, there are also two second communicating holes 1514. The two second communicating holes 1514 are respectively arranged on the two sides of the housing 150. In other words, the two second pipelines 120 respectively communicate with the two side plates 157 of the housing 150. The two second pipelines 120 may transmit the cooling working fluid with a low temperature to two opposite sides of the second sub-cavity 1512. This helps ensure temperature balance of the cooling working fluid in the inner cavity 151.

Refer to FIG. 2a. In an embodiment, a water pump 160 is further disposed in the heat dissipation apparatus 100 in this application. A pump port of the water pump 160 communicates with the circulation path of the heat dissipation apparatus 100, and the water pump 160 may be configured to provide power for the cooling working fluid to circulate. In FIG. 2a, the pump port of the water pump 160 communicates with the first pipeline 110. In some other embodiments, the pump port of the water pump 160 may alternatively communicate with the second pipeline 120. Further, in some embodiments, there may be a plurality of water pumps 160. Pump ports of some water pumps 160 communicate with the first pipeline 110, and pump ports of the other water pumps 160 communicate with the second pipeline 120. The plurality of water pumps 160 work together, to jointly provide power for the cooling working fluid to circulate. It may be understood that, in some embodiments, the water pump 160 may alternatively be disposed inside the condenser 140 or the evaporator 130.

In FIG. 5, the condenser 140 is disposed above the evaporator 130 in the gravity direction, so that the water pump 160 can be omitted. Specifically, in this embodiment, the cooling working fluid in the condenser 140 may be transmitted to the second sub-cavity 1512 through the second pipeline 120 under an action of gravity. The cooling working fluid flows into the first sub-cavity 1511 through the flow guiding hole 1521 against the gravity direction, and after dissipating heat for the power semiconductor device 201, flows back to the condenser 140 through the first pipeline 110 against the gravity direction for cooling. In this case, the condenser 140 may further include a liquid inlet 141 and a liquid outlet 142. The liquid inlet 141 communicates with the first pipeline 110, and the liquid outlet 142 communicates with the second pipeline 120. The liquid inlet 141 needs to be located above the liquid outlet 142 in the gravity direction.

In a working process of the heat dissipation apparatus 100 in this application, the cooling working fluid with a high temperature has a low density, and may automatically rise against the gravity direction and enter the first pipeline 110, and then enter the upper condenser 140 through the first pipeline 110 from the liquid inlet 141 for cooling. The cooled cooling working fluid has a high density, enters the second pipeline 120 through the liquid outlet 142 under the action of gravity, and further flows back to the inner cavity 151 through the second pipeline 120. According to the heat dissipation apparatus 100 in this embodiment, a gravity heat pipe may be formed, so that the cooling working fluid can automatically circulate. In addition, because the water pump 160 is omitted, an overall size of the heat dissipation apparatus 100 is reduced, and energy consumption is further reduced.

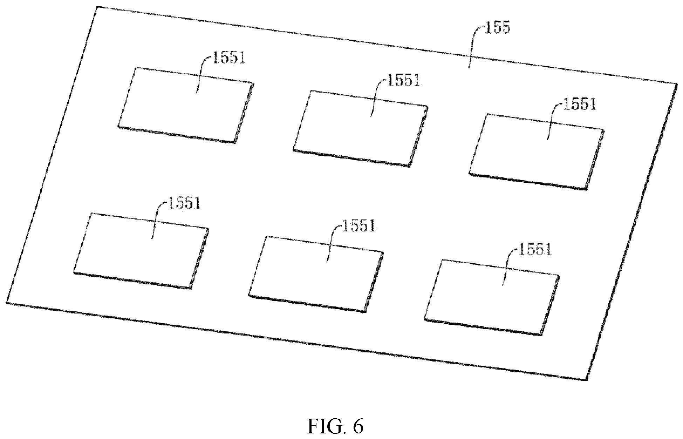

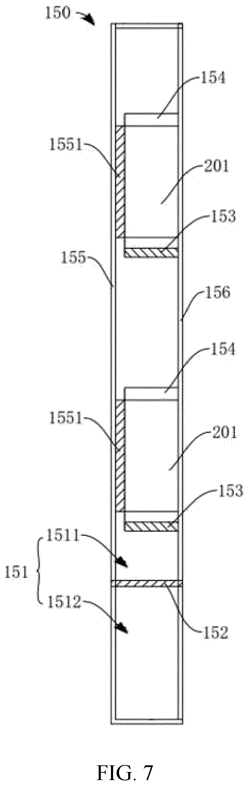

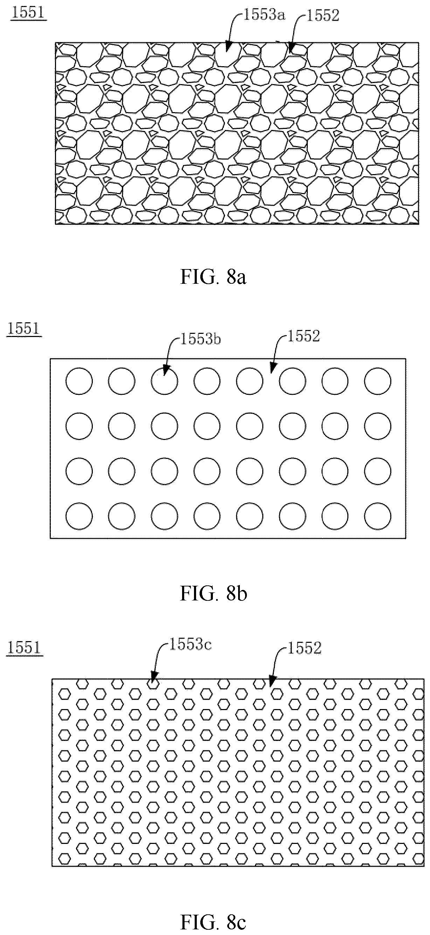

Refer to FIG. 6. In an embodiment, for the heat dissipation apparatus 100 in this application, each power semiconductor device 201 may be fastened to an inner side wall of the rear cover 156. Correspondingly, an inner side wall of the front cover 155 may be provided with a fitting area. A position of the fitting area is at least partially aligned with a position of the power semiconductor device 201. The fitting area is further provided with a bump 1551. The bump 1551 protrudes toward a direction of the power semiconductor device 201. Synchronously refer to FIG. 7. After the front cover 155 is assembled on the housing 150, an end surface that is of the bump 1551 of the front cover 155 and that faces the power semiconductor device 201 abuts against and is in contact with the power semiconductor device 201. In this embodiment, the bump 1551 is further provided with a pore 1552 (as shown in FIG. 8a), and the pore 1552 is at least located on the end surface that is of the bump 1551 and that faces the power semiconductor device 201. In this way, the pore 1552 of the bump 1551 abuts against and is in contact with the power semiconductor device 201.

In FIG. 8a, the pore 1552 may be a layer structure having a pore shape. In other words, the pore 1552 is formed by irregular arrangement of a plurality of holes 1553a of different sizes. When the pore 1552 of the bump 1551 is attached to a surface of the power semiconductor device 201, more nucleation points (nucleation) may be formed on the surface of the power semiconductor device 201. The nucleation point is also referred to as nucleation, and is a breeding center in which the cooling working fluid is subject to phase transition. In this embodiment of this application, the nucleation point may be understood as a "vaporization center" in which the cooling working fluid in the liquid state vaporizes. The cooling working fluid vaporizes at the nucleation points, to absorb more heat and form better heat exchange effect. This improves the heat dissipation effect of the cooling working fluid for the power semiconductor device 201.

In an embodiment, the fitting area may alternatively be completely aligned with the power semiconductor device 201. In other words, a shape, a size, and a position of the fitting area are all disposed corresponding to those of the power semiconductor device 201, so that the bump 1551 can be in full contact with the surface of the power semiconductor device 201. In this case, more nucleation points are formed on the surface of the power semiconductor device 201, and the cooling working fluid has better heat dissipation effect for the power semiconductor device 201. In an embodiment, the pore 1552 may alternatively be configured as dense protruding portions having a protruding shape. As shown in FIG. 8b, the protruding portions may be configured as dense pillars 1553b, or as shown in FIG. 8c, the protruding portions are configured as dense lattices 1553c. When the plurality of protruding portions are in contact with the surface of the power semiconductor device 201, a plurality of nucleation points may also be formed on the surface of the power semiconductor device 201.

In an embodiment, when the inner cavity 151 is provided with the support cradles 158, the plurality of support cradles 158 are spaced from each other. In addition, there is a first distance between any two adjacent support cradles 158. The first distance may be understood as a shortest spacing distance between two adjacent support cradles 158.

In this case, as shown in FIG. 8a, when the pore 1552 of the bump 1551 is formed by irregular arrangement of the plurality of holes 1553a, an inner diameter of any one of the holes 1553a is less than the first distance between the two support cradles 158. Such disposition can ensure that the pore 1552 is arranged more densely than the support cradles 158, to ensure that the nucleation points are located at the pore 1552 of the bump 1551.

As shown in FIG. 8b or FIG. 8c, when the pore 1552 of the bump 1551 is formed by gaps between the plurality of protruding portions (the pillars 1553b or the lattices 1553c) spaced from each other, a distance between any two adjacent protruding portions is also less than the first distance. This can also ensure that the pore 1552 is arranged more densely, and ensure that the core points are located at the pore 1552 of the bump 1551. This ensures the heat dissipation effect of the cooling working fluid for the power semiconductor device 201.

It should be noted that, in FIG. 6 and FIG. 7, the power semiconductor device 201 is fastened to the rear cover 156, and the bump 1551 protruding from the fitting area is formed on the front cover 155. In some other embodiments, the power semiconductor device 201 may alternatively be fastened to the front cover 155, and the rear cover 156 is provided with a fitting area that is at least partially aligned with the power semiconductor device 201. Then, the fitting area is provided with a bump 1551, and the bump 1551 is provided with a pore 1552. In such a disposing manner, a surface of the bump 1551 having the pore 1552 can also be in contact with the power semiconductor device 201, and a plurality of nucleation points are formed on the power semiconductor device 201. This improves the heat dissipation effect of the cooling working fluid for the power semiconductor device 201.

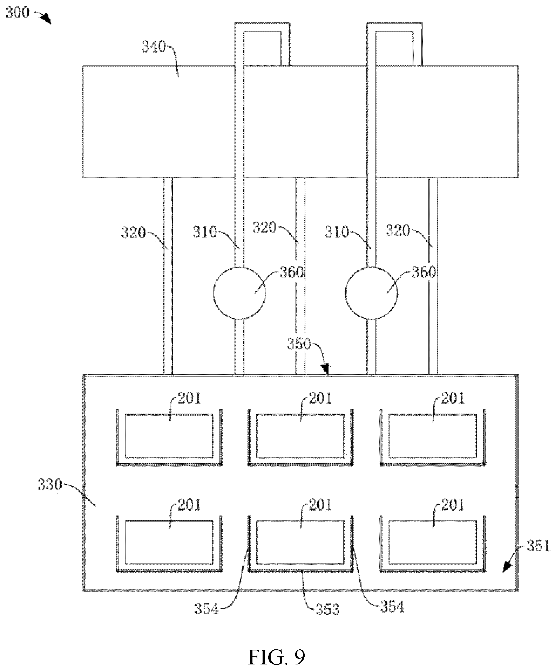

FIG. 9 shows a structure of another heat dissipation apparatus 300 according to this application. The heat dissipation apparatus 300 includes a plurality of elements that are the same as those of the heat dissipation apparatus 100. Therefore, numbers of similar elements are the same, except that reference numerals start with "3" instead of "1".

In the embodiment shown in FIG. 9, the heat dissipation apparatus 300 also includes a first pipeline 310, a second pipeline 320, an evaporator 330, and a condenser 340. The first pipeline 310 communicates with the evaporator 330 and the condenser 340, the second pipeline 320 also communicates with the evaporator 330 and the condenser 340, and a cooling working fluid is injected into the heat dissipation apparatus 300, to form a circulation path of "the evaporator 330-the first pipeline 310-the condenser 340-the second pipeline 320-the evaporator 330" of the cooling working fluid.

The evaporator 330 includes a housing 350, and a heat emitting element 201 is fastened in the housing 350. After forming heat exchange with the heat emitting element 201 in the housing 350, the cooling working fluid flows from the first pipeline 310 to the condenser 340. After the condenser 340 cools the cooling working fluid, the cooling working fluid flows back to the evaporator 330 through the second pipeline 320 and forms heat exchange with the heat emitting element 201 again.

In this embodiment, the heat emitting element 201 may also correspond to the power semiconductor device 201 in the inverter 200. In addition, in FIG. 9, there are also six power semiconductor devices 201.

The housing 350 has a sealed inner cavity 351. In addition, in this embodiment, the housing 350 is provided with a flow limiting groove corresponding to each power semiconductor device 201. The power semiconductor device 201 is accommodated and fastened in the flow limiting groove, and the flow limiting groove has an opening. Specifically, in this embodiment, the housing 150 is also provided with a flow limiting plate 353 and a flow limiting wall 354. The flow limiting plate 353 is located at the bottom of the power semiconductor device 201. There are two flow limiting walls 354. The two flow limiting walls 354 are respectively arranged on two sides of the power semiconductor device 201, and are respectively fastened to two opposite ends of the flow limiting plate 353. The flow limiting plate 353 and the flow limiting walls 354 are separately spaced from the power semiconductor device 201.

The housing 350 further includes a front cover 355 and a rear cover 356 spaced from each other. The flow limiting plate 353 and the flow limiting walls 354 are separately fastened to the front cover 355 and the rear cover 356. In this way, for a same power semiconductor device 201, a flow limiting plate 353, two flow limiting walls 354, a part of the front cover 355, and a part of the rear cover 356 that are located around the power semiconductor device 201 jointly enclose to form one flow limiting groove. It should be noted that, in this embodiment, that "the flow limiting plate 353 is located at the bottom of the power semiconductor device 201" may be understood as that the flow limiting plate 353 is spaced from the power semiconductor device 201 in one direction. That "the two flow limiting walls 354 are respectively arranged on two sides of the power semiconductor device 201" may be understood as that the two flow limiting walls 354 are located on two opposite sides of a same power semiconductor device 201 in a direction perpendicular to a direction in which the flow limiting plate 353 is spaced from the power semiconductor device 201. In this way, in FIG. 9, the flow limiting plate 353 is spaced from the power semiconductor device 201 in a gravity direction, and the two flow limiting walls 355 are located on the two opposite sides of the power semiconductor device 201 in a horizontal direction. In this case, the opening of the formed flow limiting groove faces upward against the gravity direction. In other words, the power semiconductor device 201 is fastened in the flow limiting groove with the opening facing upward. In some other embodiments, the opening of the flow limiting groove may alternatively face downward in the gravity direction or be provided facing any direction.

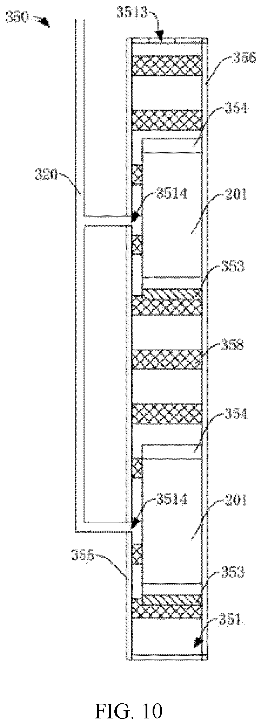

The housing 350 is provided with a first communicating hole 3513 and a second communicating hole 3514. The first pipeline 310 communicates with the inner cavity 351 through the first communicating hole 3513. The second pipeline 320 communicates with the inner cavity 351 through the second communicating hole 3514. In an embodiment, the first communicating hole 3513 is located above the second communicating hole 3514. In the figure, the first communicating hole 3513 is further located at the top of the housing 350, that is, at the top of the inner cavity 351. Refer to FIG. 10. For the heat dissipation apparatus 300 provided in this embodiment, the second communicating hole 3514 further communicates with the flow limiting groove. In other words, in this embodiment, the second pipeline 320 communicates with the flow limiting groove. The cooling working fluid cooled by the condenser 340 directly flows into the flow limiting groove through the second pipeline 320, and enters another area of the inner cavity 351 from the opening of the flow limiting groove after exchanging heat with the power semiconductor device 201.

Similar to the principle of the heat dissipation apparatus 100, a principle of the heat dissipation apparatus 300 provided in this embodiment is that, when the cooling working fluid directly enters the flow limiting groove through the second pipeline 320, the cooling working fluid may reach the power semiconductor device 201 through a short path, and form heat exchange with the power semiconductor 201. In this case, the cooling working fluid has a low temperature, and has better heat dissipation effect for the power semiconductor device 201. After exchanging heat and entering the another area of the inner cavity 351 from the opening of the flow limiting groove, the cooling working fluid may flow upward and enter the first pipeline 310 through the first communicating hole 3513, and then flow back to the condenser 340 for cooling.

Compared with a heat dissipation manner in the conventional technology in which the cooling working fluid directly enters the inner cavity 151a, a heat dissipation manner of the heat dissipation apparatus 300 provided in this embodiment may form better heat dissipation effect for the power semiconductor device 201.

In FIG. 10, the power semiconductor device 201 is fastened to the rear cover 356, the second communicating hole 3514 is provided on the front cover 355, and the second pipeline 320 transmits the cooling working fluid to the flow limiting groove from a side of the front cover 355. Further, the second communicating hole 3514 may be provided in alignment with a geometric center of the power semiconductor device 201, so that the cooling working fluid can spread around from the center of the power semiconductor device 201, and form more even heat exchange effect.

It may be understood that the power semiconductor device 201 may alternatively be fastened to a side of the front cover 355, and the second communicating hole 3514 is provided on a side of the rear cover 356 and is located in the flow limiting groove (as shown in FIG. 9). Such a structure may also form good heat dissipation effect for the power semiconductor device 201.

In an embodiment, the condenser 340 is located above the evaporator 330 in the gravity direction. In this way, the cooling working fluid in the condenser 340 can be transmitted to the flow limiting groove through the second pipeline 320 under an action of gravity. After dissipating heat for the power semiconductor device 201, the cooling working fluid flows into the first pipeline 310 through the opening, and flows back to the condenser 340 against the gravity direction for cooling. In this case, according to the heat dissipation apparatus 300, a form of a gravity heat pipe may also be formed, and circulation of the cooling working fluid may be implemented through phase transition of the cooling working fluid. This reduces energy consumption.

In an embodiment, the opening of the flow limiting groove faces upward against the gravity direction. In this way, the power semiconductor device 201 can be soaked in the cooling working fluid in the flow limiting groove under the action of gravity, and the cooling working fluid with a low temperature that flows from the second pipeline 320 can be in fuller contact with the power semiconductor device 201. This improves a heat dissipation capability of the heat dissipation apparatus 300.

In the embodiment of FIG. 10, the power semiconductor devices 201 are further arranged vertically in the gravity direction. In other words, upper first power semiconductor devices 201a and lower second power semiconductor devices 201b are formed. The flow limiting grooves are also distributed vertically. Each flow limiting groove accommodates one second communicating hole 3514. In this case, a same second pipeline 320 may be connected to both an upper second communicating hole 3514 and a lower second communicating hole 3514, and transmit the cooling working fluid to an upper flow limiting groove and a lower flow limiting groove at the same time. Such a structure can reduce a quantity of second pipelines 320, and can also ensure the heat dissipation effect of the heat dissipation apparatus 300.

In the embodiment of the heat dissipation apparatus 300 shown in FIG. 9 and FIG. 10 in this application, a plurality of support cradles 358 and a water pump 360 may also be disposed, or the condenser 340 is disposed above the evaporator 330, so that the cooling working fluid automatically circulates through a change of a density of the cooling working fluid. In addition, in some embodiments, a structure similar to the bump 1551 in the embodiment of the heat dissipation apparatus 100 may be further provided on the front cover 355 or the rear cover 356, to increase nucleation points on the power semiconductor device 201. A specific structure and effect in the foregoing embodiment are respectively similar to a specific structure and effect in the corresponding embodiment of the heat dissipation apparatus 100. Details are not described herein in this specification.

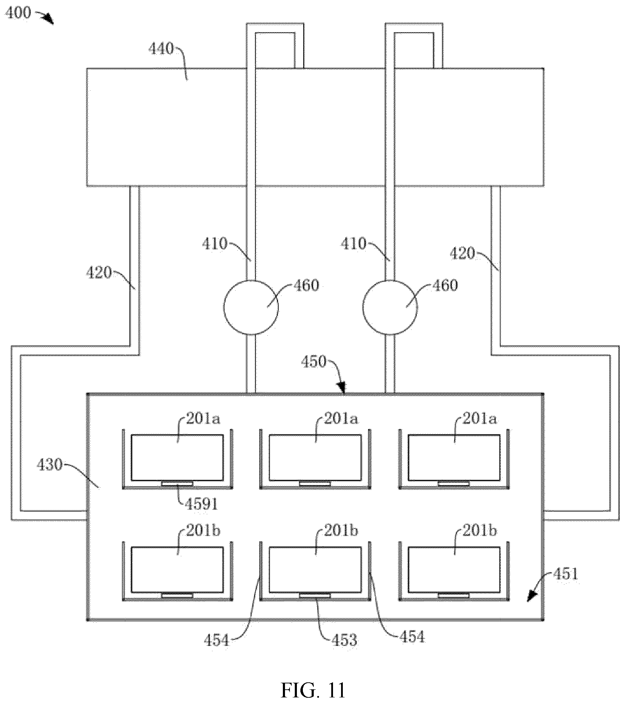

FIG. 11 shows a structure of still another heat dissipation apparatus 400 according to this application. The heat dissipation apparatus 400 also includes a plurality of elements that are the same as those of the heat dissipation apparatus 100. Therefore, numbers of similar elements are the same, except that reference numerals start with "4" instead of "1".

In the embodiment shown in FIG. 11, the heat dissipation apparatus 400 also includes a first pipeline 410, a second pipeline 420, an evaporator 430, and a condenser 440. The first pipeline 410 communicates with the evaporator 430 and the condenser 440, the second pipeline 420 also communicates with the evaporator 430 and the condenser 440, and a cooling working fluid is injected into the heat dissipation apparatus 400, to form a circulation path of "the evaporator 430-the first pipeline 410-the condenser 440-the second pipeline 420-the evaporator 430" of the cooling working fluid.

The evaporator 430 includes a housing 450, and a heat emitting element 201 is fastened in the housing 450. After forming heat exchange with the heat emitting element 201 in the housing 450, the cooling working fluid flows from the first pipeline 410 to the condenser 440. After the condenser 440 cools the cooling working fluid, the cooling working fluid flows back to the evaporator 430 through the second pipeline 420 and forms heat exchange with the heat emitting element 201 again.

In this embodiment, the heat emitting element 201 may also correspond to the power semiconductor device 201 in the inverter 200. In addition, in FIG. 11, there are also six power semiconductor devices 201.

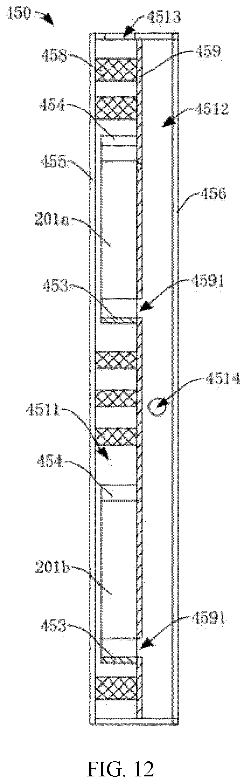

The housing 450 has a sealed inner cavity 451, and the housing 450 further includes a front cover 455 and a rear cover 456 spaced from each other. The inner cavity 451 is formed between the front cover 455 and the rear cover 456. Refer to FIG. 12. In addition, in this embodiment, the evaporator 430 further includes a middle division plate 459. The middle division plate 459 is located in the inner cavity 451, and is configured to divide the inner cavity 451 into a front cavity 4511 and a rear cavity 4512. The front cavity 4511 is located between the middle division plate 459 and the front cover 455. The rear cavity 4512 is located between the middle division plate 459 and the rear cover 456. In the embodiment shown in the figure, the housing 450 is a cuboid, and the middle division plate 459 is arranged in a gravity direction, so that the front cavity 4511 and the rear cavity 4512 each are also rectangular cavities. In some other embodiments, the middle division plate 459 may alternatively be obliquely disposed, so that the front cavity 4511 and the rear cavity 4512 each are right-angle trapezoidal cavities. This does not affect function implementation of the heat dissipation apparatus 100 in this application.

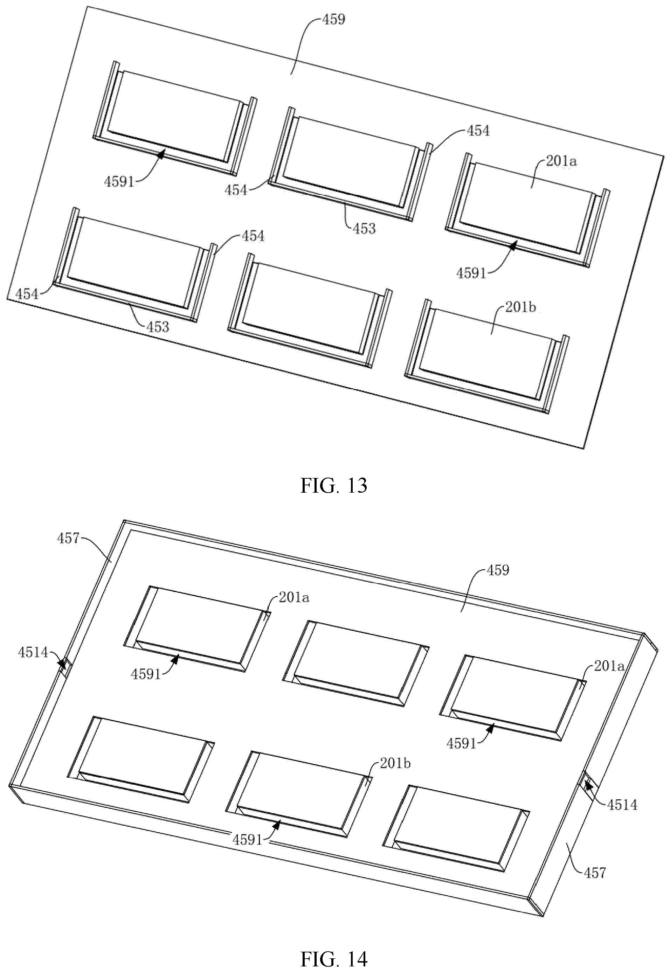

In this embodiment, the plurality of power semiconductor devices 201 are all fastened in the front cavity 4511. Specifically, the plurality of power semiconductor devices 201 may be fastened to the middle division plate 459 (as shown in FIG. 13), or may be fastened to the front cover 455. The first pipeline 410 communicates with the front cavity 4511. The second pipeline 420 communicates with the rear cavity 4512. It may be understood that the housing 450 is provided with a first communicating hole 4513 and a second communicating hole 4514. The first pipeline 410 communicates with the front cavity 4511 through the first communicating hole 4513. The second pipeline 420 communicates with the rear cavity 4512 through the second communicating hole 4514. In an embodiment, the first communicating hole 4513 is located above the second communicating hole 4514 in a vertical direction. In the figure, the first communicating hole 4513 is further located at the top of the housing 450, that is, at the top of the inner cavity 451.

In the heat dissipation apparatus 400 in this embodiment, the housing 450 is provided with a flow limiting groove corresponding to each power semiconductor device 201. The power semiconductor device 201 is accommodated and fastened in the flow limiting groove. In other words, the front cavity 4511 of the housing 450 is provided with the flow limiting groove configured to accommodate the power semiconductor device 201. Specifically, in this embodiment, the housing 450 also includes a flow limiting plate 453 and a flow limiting wall 454. The flow limiting plate 453 is located at the bottom of the power semiconductor device 201. There are two flow limiting walls 454. The two flow limiting walls 454 are respectively arranged on two sides of the power semiconductor device 201, and are respectively fastened to two opposite ends of the flow limiting plate 453. The flow limiting plate 453 and the flow limiting walls 454 are separately spaced from the power semiconductor device 201. It may be understood that, in this embodiment, that the flow limiting plate 453 is located at the bottom of the power semiconductor device 201 may also be understood as that the flow limiting plate 453 is spaced from the power semiconductor device 201 in one direction.

The flow limiting plate 453 is fastened to both the front cover 455 and the middle division plate 459, and the flow limiting walls 454 are also fastened to both the front cover 455 and the middle division plate 459. In this way, for a same power semiconductor device 201, a flow limiting plate 453, two flow limiting walls 454, a part of the front cover 455, and a part of the middle division plate 459 that are located around the power semiconductor device 201 jointly enclose to form one flow limiting groove. In FIG. 11, the flow limiting plate 453 is further located below the power semiconductor device 201 in the gravity direction, and the flow limiting groove has an opening that faces upward and that is on a periphery of the power semiconductor device 201. In other words, the power semiconductor device 201 is fastened in the flow limiting groove with the opening facing upward.

FIG. 14 shows an internal structure of one side of the rear cavity 4512. The middle division plate 459 is further provided with a drainage hole 4591. The drainage hole 4591 is configured for the front cavity 4511 to communicate with the rear cavity 4512. In addition, in this embodiment, the drainage hole 4591 further communicates with the flow limiting groove. In other words, the drainage hole 4591 is located between the power semiconductor device 201 and the flow limiting plate 453 and/or the flow limiting wall 454 that correspond/corresponds to the power semiconductor device 201. Based on the foregoing descriptions of the circulation path of the cooling working fluid, the cooling working fluid cooled by the condenser 440 first flows, through the second pipeline 420, into the rear cavity 4512 close to the rear cover 456. Then, the cooling working fluid may pass through the drainage hole 4591, and then enter the flow limiting groove located in the front cavity 4511, to form heat exchange with the power semiconductor device 201. Because the drainage hole 4591 is located between the power semiconductor device 201 and the flow limiting plate 453 and/or the flow limiting wall 454, when the cooling working fluid enters the front cavity 4511 from the rear cavity 4512 through the drainage hole 4591, the cooling working fluid directly enters the flow limiting groove and enters another area of the front cavity 4511 from the opening of the flow limiting groove after exchanging heat with the power semiconductor device 201.

Similar to the principle of the heat dissipation apparatus 300, a principle of the heat dissipation apparatus 400 provided in this embodiment is that, when the opening of the flow limiting groove faces upward in the gravity direction, the cooling working fluid enters the flow limiting groove through the second pipeline 420 and the rear cavity 4512 in sequence, and may reach the power semiconductor device 201 through a short path, stay in the flow limiting groove for a long time under an action of gravity, and then flow into the another area of the front cavity 4511 after fully exchanging heat with the power semiconductor device 201. In this case, the cooling working fluid has a low temperature, and has better heat dissipation effect for the power semiconductor device 201. After exchanging heat and entering the another area of the front cavity 4511 from the upper opening of the flow limiting groove, the cooling working fluid may flow upward and enter the first pipeline 410 through the first communicating hole 3513, and then flow back to the condenser 440 for cooling. It should be noted that, in some other embodiments, the opening of the flow limiting groove may alternatively face any direction, provided that the cooling working fluid flowing from the rear cavity 4512 can form heat exchange with the power semiconductor device 201 through a shorter flow path. Compared with a heat dissipation manner in the conventional technology in which the cooling working fluid directly enters the inner cavity 151a, a heat dissipation manner of the heat dissipation apparatus 400 provided in this embodiment may form better heat dissipation effect for the power semiconductor device 201.

In FIG. 13, the power semiconductor devices 201 may also be arranged vertically in the gravity direction. In other words, first power semiconductor devices 201a located above and second power semiconductor devices 201b located below are formed. Accordingly, the flow limiting grooves are also distributed vertically. A drainage hole 4591 is provided between each flow limiting groove and each power semiconductor device 201. In this case, as shown in FIG. 14, in a horizontal direction perpendicular to the gravity direction, the first power semiconductor device 201a and the second power semiconductor device 201b form, on an inner surface of the housing 450, two projection areas 201a' and 201b' spaced from each other. The second communicating hole 4514 that is of the second pipeline 420 and that communicates with the housing 450 is also located on the same inner surface. The second communicating hole 4514 is further located between the two projection areas 201a' and 201b'.

Specifically, the cooling working fluid that enters the rear cavity 4512 from the second communicating hole 4514 may flow in two opposite directions. In other words, in this embodiment, after entering the rear cavity 4512, the cooling working fluid may flow upward and downward in the gravity direction. Then, the cooling working fluid flows into the flow limiting groove from drainage holes 4591 respectively corresponding to the first power semiconductor device 201a and the second power semiconductor device 201b, to form heat dissipation effect for both the first power semiconductor device 201a and the second power semiconductor device 201b. The cooling working fluid flows in two opposite directions. This ensures evenness of heat dissipation of the power semiconductor devices 201.

It may be understood that, when the first power semiconductor device 201a and the second power semiconductor device 201b are spaced from each other in the horizontal direction, the second communicating hole 4514 may also be located between projection areas of the two power semiconductor devices 201, and the cooling working fluid enters from an upper part and/or a lower part of the rear cavity 4512 in the gravity direction, spreads to left and right sides in the horizontal direction, and flows into each power semiconductor device 201. This can also improve the evenness of heat dissipation.

In FIG. 14, there are two second pipelines 420, and each second pipeline 420 communicates with one side plate 457. In other words, each of two second communicating holes 4514 is located on one side plate 457. The two second pipelines 420 may transmit the cooling working fluid with a low temperature to two opposite sides of the rear cavity 4512. This helps ensure temperature balance of the cooling working fluid in the rear cavity 4512.

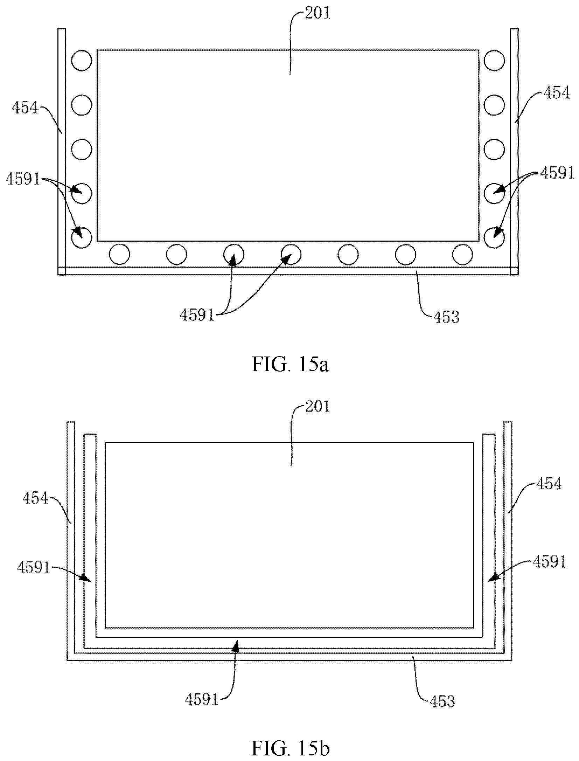

Refer to FIG. 15a. In an embodiment, there may be a plurality of drainage holes 4591. The plurality of drainage holes 4591 are spaced from each other on a periphery of the power semiconductor device 201. Specifically, the plurality of drainage holes 4591 may be spaced from each other in a length direction of the flow limiting plate 453, and the plurality of drainage holes 4591 may also be spaced from each other in a length direction of the flow limiting wall 454. A larger total area of the drainage holes 4591 indicates more cooling working fluids that enter the flow limiting groove from the drainage holes 4591. Therefore, better heat dissipation effect can be formed. In addition, the plurality of drainage holes 4591 are spaced from each other along the periphery of the power semiconductor device 201, so that the cooling working fluid can evenly enter the flow limiting groove along an outer contour of the power semiconductor device 201, to evenly dissipate heat for the power semiconductor device 201. This can also improve the heat dissipation effect of the cooling working fluid.

In the embodiment shown in FIG. 15b, a shape of the drainage hole 4591 may alternatively be a strip. The strip-shaped drainage hole 4591 extends in a length direction of the flow limiting plate 453, and the strip-shaped drainage holes 4591 further extend in length directions of the two flow limiting walls 454. The strip-shaped drainage holes 4591 also provide a large area for more cooling working fluids to evenly enter the flow limiting groove. In FIG. 15b, the strip-shaped drainage holes 4591 further sequentially communicate with each other.

In an embodiment, the condenser 440 may also be disposed above the evaporator 430 in the gravity direction, so that a form of a gravity heat pipe is formed. In this way, the cooling working fluid in the condenser 440 is transmitted to the flow limiting groove through the second pipeline 420 under an action of gravity. After dissipating heat for the power semiconductor device 201, the cooling working fluid flows into the first pipeline 410 through the opening, and flows back to the condenser 440 against the gravity direction for cooling.

In the embodiment of the heat dissipation apparatus 400 shown in FIG. 11 to FIG. 15b in this application, a plurality of support cradles 458 or a water pump 460 may also be disposed. In addition, in some embodiments, a structure similar to the bump 1551 in the embodiment of the heat dissipation apparatus 100 may be further provided on an inner side wall of the front cover 455 or the middle division plate 459, to increase nucleation points on the power semiconductor device 201. A specific structure and effect in the foregoing embodiment are respectively similar to a specific structure and effect in the corresponding embodiment of the heat dissipation apparatus 100. Details are not described herein in this specification.

It should be noted that, because the middle division plate 459 is disposed in the heat dissipation apparatus 400 in this embodiment, when the support cradles 458 are disposed in the housing 450, the support cradles 458 may be fastened between the front cover 455 and the middle division plate 459, to improve structural stability of the housing 450. In some embodiments, the support cradles 458 may further pass through the middle division plate 459, and are fastened between the front cover 455 and the rear cover 456. In this case, the support cradles 458 may be fastened to the front cover 455, the middle division plate 459, and the rear cover 456 at the same time, to further improve the structural stability of the housing 450.

In addition, in embodiments of this application, the front cover and the rear cover are only used to specify two plate structures in the housing that are spaced from each other. Specific names of "front" and "rear" merely indicate a relative position relationship between the two plate structures. Specific orientations of the front cover and the rear cover in the power converter are not strictly limited in the heat dissipation apparatus in this application. In other words, the heat dissipation apparatus in this application may be fastened to the power converter by using the front cover, or may be fastened to the power converter by using the rear cover. This does not affect function implementation of a radiator in this application.

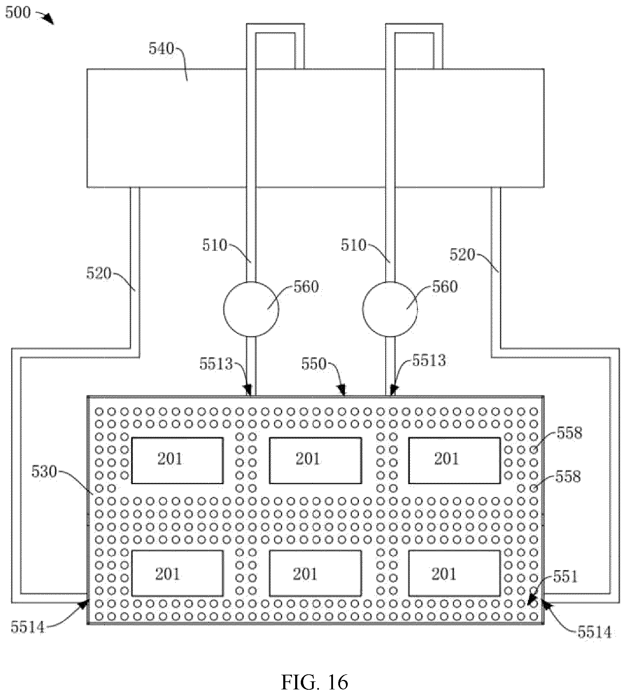

FIG. 16 shows a structure of yet another heat dissipation apparatus 500 according to this application. The heat dissipation apparatus 500 also includes a plurality of elements that are the same as those of the heat dissipation apparatus 100. Therefore, numbers of similar elements are the same, except that reference numerals start with "5" instead of "1".

In the embodiment shown in FIG. 16, the heat dissipation apparatus 500 also includes a first pipeline 510, a second pipeline 520, an evaporator 530, and a condenser 540. The first pipeline 510 communicates with the evaporator 530 and the condenser 540, the second pipeline 520 also communicates with the evaporator 530 and the condenser 540, and a cooling working fluid is injected into the heat dissipation apparatus 500, to form a circulation path of "the evaporator 530-the first pipeline 510-the condenser 540-the second pipeline 520-the evaporator 530" of the cooling working fluid.

The evaporator 530 includes a housing 550, and a heat emitting element 201 is fastened in the housing 550. After forming heat exchange with the heat emitting element 201 in the housing 550, the cooling working fluid flows from the first pipeline 510 to the condenser 540. After the condenser 540 cools the cooling working fluid, the cooling working fluid flows back to the evaporator 530 through the second pipeline 520 and forms heat exchange with the heat emitting element 201 again.

In this embodiment, the heat emitting element 201 may also correspond to the power semiconductor device 201 in the inverter 200. In addition, in FIG. 16, there are also six power semiconductor devices 201.

The housing 550 has a sealed inner cavity 551, and the housing 550 is provided with a first communicating hole 5513 and a second communicating hole 5514. The first pipeline 510 communicates with the inner cavity 551 through the first communicating hole 5513. The second pipeline 520 communicates with the inner cavity 551 through the second communicating hole 5514. In an embodiment, the first communicating hole 5513 is located above the second communicating hole 5514 in a gravity direction. In the figure, the first communicating hole 5513 is further located at the top of the housing 550, that is, at the top of the inner cavity 551.

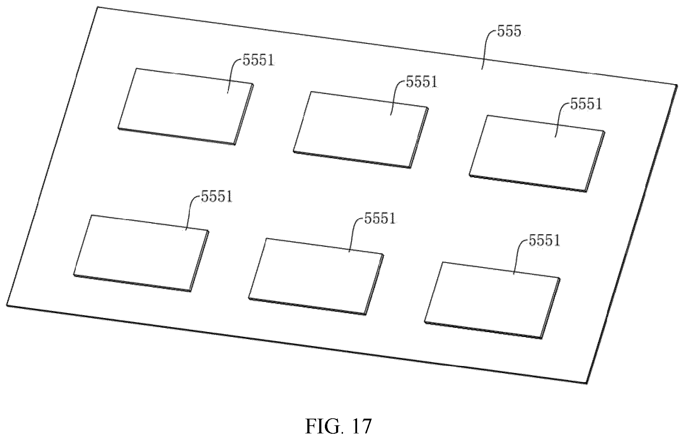

In addition, in this embodiment, the housing 550 further includes a front cover 555 and a rear cover 556 spaced from each other. Refer to FIG. 17. In an embodiment, for the heat dissipation apparatus 500 in this application, each power semiconductor device 201 may be fastened to the rear cover 556. Correspondingly, the front cover 555 may be provided with a fitting area. A position of the fitting area is at least partially aligned with that of the power semiconductor device 201. The fitting area is provided with a bump 5551. The bump 5551 protrudes from the front cover 555 toward the power semiconductor device 201, and an end surface that is of the bump 5551 and that faces the power semiconductor device 201 is in contact with the power semiconductor device 201.

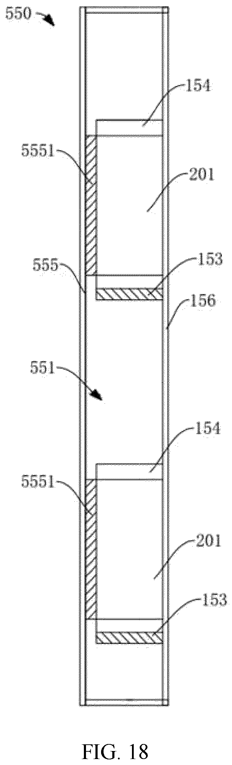

Synchronously refer to FIG. 18. After the front cover 555 is assembled on the housing 550, the bump 5551 of the front cover 555 abuts against and is in contact with the power semiconductor device 201. In this embodiment, the bump 5551 is further provided with a pore 5552, and the pore 5552 is at least located on the end surface that is of the bump 5551 and that faces the power semiconductor device 201. In this way, the pore 5552 of the bump 5551 abuts against and is in contact with the power semiconductor device 201.

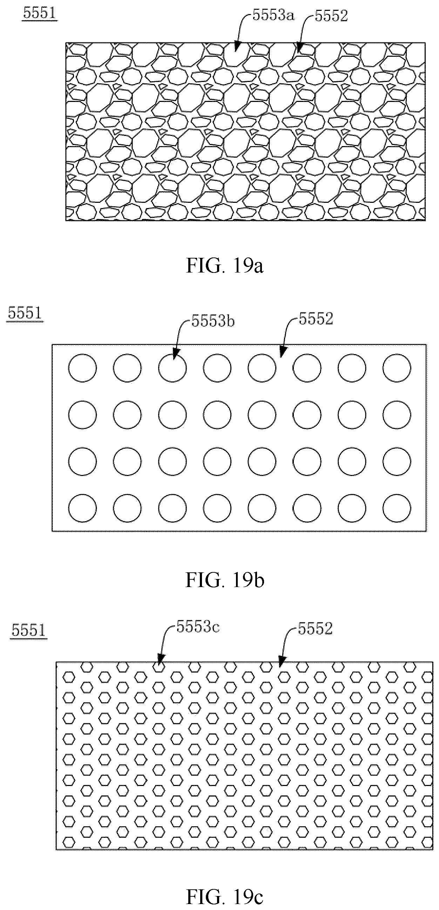

In FIG. 19a, the pore 5552 may be a layer structure having a pore shape. In other words, the pore 5552 is formed by irregular arrangement of a plurality of holes 5553a of different sizes. When the pore 5552 of the bump 5551 is attached to a surface of the power semiconductor device 201, more nucleation points may be formed on the surface of the power semiconductor device 201. The cooling working fluid forms better heat exchange effect at the nucleation points. This improves heat dissipation effect of the cooling working fluid for the power semiconductor device 201.

Compared with a heat dissipation manner in the conventional technology in which the cooling working fluid directly enters the inner cavity 151a, a heat dissipation manner of the heat dissipation apparatus 500 provided in this embodiment may form better heat dissipation effect for the power semiconductor device 201.

In an embodiment, the fitting area may alternatively be completely aligned with the power semiconductor device 201. In other words, a shape, a size, and a position of the fitting area are all disposed corresponding to those of the power semiconductor device 201, so that the bump 5551 can be in full contact with the surface of the power semiconductor device 201. In this case, more nucleation points are formed on the surface of the power semiconductor device 201, and the cooling working fluid has better heat dissipation effect for the power semiconductor device 201.

In an embodiment, the housing 550 is further provided with a plurality of support cradles 558 spaced from each other. A structure and effect of the support cradle 558 are similar to those of the support cradle 158 in the heat dissipation apparatus 100. The support cradles 558 may fasten the front cover 555 and the rear cover 556, and form drainage effect and distribution effect for the cooling working fluid. In the heat dissipation apparatus 500 in this embodiment, there is a first distance between any two adjacent support cradles 558. The first distance may be understood as a shortest spacing distance between two adjacent support cradles 558.

In this case, as shown in FIG. 19a, when the pore 5552 of the bump 5551 is formed by irregular arrangement of the plurality of holes 5553a, an inner diameter of any one of the holes 5553a is less than the first distance between the two support cradles 558. Such disposition can ensure that the pore 5552 is arranged more densely than the support cradles 558, to ensure that the nucleation points are located at the pore 5552 of the bump 5551.

As shown in FIG. 19b or FIG. 19c, when the pore 5552 of the bump 5551 is formed by gaps between a plurality of protruding portions (pillars 5553b shown in FIG. 19b or lattices 5553c shown in FIG. 19c) spaced from each other, a distance between any two adjacent protruding portions is also less than the first distance. This can also ensure that the pore 5552 is arranged more densely, and ensure that the core points are located at the pore 5552 of the bump 5551. This ensures the heat dissipation effect of the cooling working fluid for the power semiconductor device 201.

It should be noted that, in FIG. 17 and FIG. 18, the power semiconductor device 201 is fastened to the rear cover 556, and the bump 5551 protruding from the fitting area is formed on the front cover 555. In some other embodiments, the power semiconductor device 201 may alternatively be fastened to the front cover 555, and the rear cover 556 is provided with a fitting area that is at least partially aligned with the power semiconductor device 201. Then, the fitting area is provided with a bump 5551, and the bump 5551 is provided with a pore 5552. In such a disposing manner, a surface of the bump 5551 having the pore 5552 can also be in contact with the power semiconductor device 201, and a plurality of nucleation points are formed on the power semiconductor device 201. This improves the heat dissipation effect of the cooling working fluid for the power semiconductor device 201.

In an embodiment, the condenser 540 is located above the evaporator 530 in the gravity direction. In this way, the cooling working fluid in the condenser 540 can be transmitted to a flow limiting groove through the second pipeline 520 under an action of gravity. After dissipating heat for the power semiconductor device 201, the cooling working fluid flows into the first pipeline 510 through an opening, and flows back to the condenser 540 against the gravity direction for cooling. In this case, according to the heat dissipation apparatus 500, a form of a gravity heat pipe may also be formed, and circulation of the cooling working fluid may be implemented through phase transition of the cooling working fluid. This reduces energy consumption.

In the embodiment of the heat dissipation apparatus 500 shown in FIG. 16 to FIG. 19c in this application, a water pump 560 may also be disposed, so that the water pump 560 provides power for the cooling working fluid to circulate. A specific structure and effect in the foregoing embodiment are respectively similar to a specific structure and effect in the corresponding embodiment of the heat dissipation apparatus 100. Details are not described herein in this specification.

The foregoing descriptions are merely specific embodiments of this application, but are not intended to limit the protection scope of this application. Any variation or replacement, for example, reducing or adding a mechanical part and changing a shape of the mechanical part, readily figured out by a person skilled in the art within the technical scope disclosed in this application shall fall within the protection scope of this application. When no conflict occurs, embodiments of this application and the features in embodiments may be mutually combined. Therefore, the protection scope of this application shall be subject to the protection scope of the claims.

## Claims

1. A heat dissipation apparatus, comprising an evaporator, a condenser, and a first pipeline and a second pipeline that separately communicate with the evaporator and the condenser, wherein
the evaporator comprises a housing and a division plate, the housing has a sealed inner cavity, the division plate divides the inner cavity into a first sub-cavity and a second sub-cavity, the first pipeline communicates with the first sub-cavity, and the second pipeline communicates with the second sub-cavity; and
a heat emitting element is further fastened in the first sub-cavity, the division plate is provided with a flow guiding hole configured for the first sub-cavity to communicate with the second sub-cavity, at least a part of the flow guiding hole directly faces the heat emitting element located in the first sub-cavity, a cooling working fluid in the condenser is transmitted to the second sub-cavity through the second pipeline, and the cooling working fluid flows into the first sub-cavity through the flow guiding hole, and after dissipating heat for the heat emitting element, flows back to the condenser through the first pipeline for cooling.

2. The heat dissipation apparatus according to claim 1, wherein the cooling working fluid in the condenser is transmitted to the second sub-cavity through the second pipeline under an action of gravity, and the cooling working fluid flows into the first sub-cavity through the flow guiding hole against a gravity direction, and after dissipating heat for the heat emitting element, flows back to the condenser through the first pipeline against the gravity direction for cooling.

3. The heat dissipation apparatus according to claim 1 or 2, wherein the flow guiding hole comprises a plurality of flow guiding sub-holes, and the plurality of flow guiding sub-holes are spaced from each other and located between the heat emitting element and the division plate.

4. The heat dissipation apparatus according to any one of claims 1 to 3, wherein the heat emitting element comprises at least a first heat emitting element and a second heat emitting element, the second heat emitting element is located between the first heat emitting element and the division plate, the housing further comprises a flow limiting plate, the flow limiting plate is located between the first heat emitting element and the second heat emitting element, the flow limiting plate is provided with a plurality of penetrated apertures, and the apertures are configured to block a bubble flowing to the first heat emitting element.

5. The heat dissipation apparatus according to claim 4, wherein the housing further comprises a flow limiting wall, the flow limiting wall is fastened to the flow limiting plate and located on at least one side of the first heat emitting element, and the flow limiting wall is also configured to block a bubble flowing to the first heat emitting element.

6. The heat dissipation apparatus according to any one of claims 1 to 5, wherein the housing comprises a front cover and a rear cover that are spaced from each other and fastened, the inner cavity is further provided with a plurality of support cradles spaced from each other, the heat emitting element is fastened to the front cover or the rear cover, two opposite ends of each support cradle are respectively fastened to the front cover and the rear cover, and the support cradles are configured to improve structural stability of the housing.

7. The heat dissipation apparatus according to claim 6, wherein the heat emitting element is fastened to an inner side wall of one of the front cover and the rear cover, an inner side wall of the other cover is provided with a fitting area, a position of the fitting area is at least partially aligned with that of the heat emitting element, the fitting area is provided with a bump, the bump protrudes toward the heat emitting element and is in contact with the heat emitting element, the bump further has a pore, and the pore is at least located on an end surface that is of the bump and that is in contact with the heat emitting element.

8. The heat dissipation apparatus according to claim 7, wherein there is a first distance between any two adjacent support cradles, the pore of the bump is formed by irregular arrangement of a plurality of holes, and an inner diameter of any one of the holes is less than the first distance; or
the bump comprises a plurality of protruding portions spaced from each other, gaps between the plurality of protruding portions form the pore, and a distance between any two adjacent protruding portions is less than the first distance.

9. The heat dissipation apparatus according to any one of claims 1 to 8, wherein the heat dissipation apparatus comprises a water pump, a pump port of the water pump communicates with the first pipeline and/or the second pipeline, and the water pump is configured to drive circulation of the cooling working fluid.

10. A heat dissipation apparatus, comprising an evaporator, a condenser, and a first pipeline and a second pipeline that separately communicate with the evaporator and the condenser, wherein
the evaporator comprises a housing, the housing has a sealed inner cavity, the inner cavity is provided with a flow limiting groove, the flow limiting groove has an opening, a heat emitting element is fastened in the flow limiting groove, and the second pipeline communicates with the flow limiting groove; and
a cooling working fluid in the condenser is transmitted to the flow limiting groove through the second pipeline, and after dissipating heat for the heat emitting element, the cooling working fluid flows back to the condenser through the first pipeline for cooling.

11. The heat dissipation apparatus according to claim 10, wherein the housing comprises a front cover and a rear cover that are spaced from each other and fastened, and a flow limiting plate and a flow limiting wall that are connected between the front cover and the rear cover; and
the heat emitting element is located between the front cover and the rear cover, and is fastened to the front cover or the rear cover, the flow limiting plate is located at the bottom of the heat emitting element, two flow limiting walls are located on two sides of the heat emitting element, and the front cover, the rear cover, the flow limiting plate, and the flow limiting walls jointly enclose to form the flow limiting groove.

12. The heat dissipation apparatus according to claim 10 or 11, wherein the cooling working fluid in the condenser is transmitted to the flow limiting groove through the second pipeline under an action of gravity, and after dissipating heat for the heat emitting element, the cooling working fluid flows into the first pipeline through the opening, and flows back to the condenser against a gravity direction for cooling.

13. The heat dissipation apparatus according to claim 12, wherein the opening of the flow limiting groove faces upward against the gravity direction.

14. A heat dissipation apparatus, comprising an evaporator, a condenser, and a first pipeline and a second pipeline that separately communicate with the evaporator and the condenser, wherein
the evaporator comprises a housing, the housing has a sealed inner cavity, the housing comprises a front cover, a middle division plate, and a rear cover that are sequentially spaced from each other, the middle division plate divides the inner cavity into a front cavity close to the front cover and a rear cavity close to the rear cover, the first pipeline communicates with the front cavity, and the second pipeline communicates with the rear cavity;
the front cavity is provided with a flow limiting groove, a heat emitting element is fastened in the flow limiting groove, the flow limiting groove has an opening, and a part of an area of the front cover and a part of an area of the middle division plate are further configured to form the flow limiting groove; and
the middle division plate is provided with a drainage hole communicating with the flow limiting groove and the rear cavity, a cooling working fluid in the condenser is transmitted to the rear cavity through the second pipeline, and the cooling working fluid flows into the flow limiting groove through the drainage hole, and after dissipating heat for the heat emitting element, flows back to the condenser through the first pipeline for cooling.

15. The heat dissipation apparatus according to claim 14, wherein the housing comprises a flow limiting plate and a flow limiting wall that are connected between the front cover and the middle division plate; and
the heat emitting element is fastened to the front cover or the middle division plate, the flow limiting plate is located at the bottom of the heat emitting element, two flow limiting walls are located on two sides of the heat emitting element, and the front cover, the middle division plate, the flow limiting plate, and the flow limiting walls jointly enclose to form the flow limiting groove.

16. The heat dissipation apparatus according to claim 15, wherein there are a plurality of drainage holes, and the plurality of drainage holes are spaced from each other in a length direction of the flow limiting wall and/or a length direction of the flow limiting wall; or
the drainage holes are strip-shaped, and the strip-shaped drainage holes extend in a length direction of the flow limiting wall and/or a length direction of the flow limiting wall.

17. The heat dissipation apparatus according to any one of claims 14 to 16, wherein the cooling working fluid in the condenser is transmitted to the flow limiting groove through the second pipeline under an action of gravity, and after dissipating heat for the heat emitting element, the cooling working fluid flows into the first pipeline through the opening, and flows back to the condenser against a gravity direction for cooling.

18. The heat dissipation apparatus according to any one of claims 14 to 17, wherein the heat emitting element comprises at least a first heat emitting element and a second heat emitting element, the first heat emitting element and the second heat emitting element are spaced from each other and fastened, and in a direction perpendicular to a direction in which the first heat emitting element and the second heat emitting element are spaced from each other, the first heat emitting element and the second heat emitting element form, on an inner surface of the housing, two projection areas spaced from each other; and
the second pipeline has a second communicating hole communicating with the housing, the second communicating hole and the two projection areas are located on the same inner surface of the housing, and the second communicating hole is located between the two projection areas.

19. The heat dissipation apparatus according to claim 18, wherein the first heat emitting element is located above the second heat emitting element in the gravity direction, the housing further comprises two opposite side plates, the two opposite side plates are respectively arranged on two sides of the front cover and are separately connected between the front cover and the rear cover, there are two second pipelines, and each second pipeline is connected to one side plate.

20. A heat dissipation apparatus, comprising an evaporator, a condenser, and a first pipeline and a second pipeline that separately communicate with the evaporator and the condenser, wherein
the evaporator comprises a housing, the housing has a sealed inner cavity, the housing further comprises a front cover and a rear cover that are spaced from each other and fastened, a heat emitting element is fastened to an inner side wall of one of the front cover and the rear cover, an inner side wall of the other cover is provided with a fitting area, a position of the fitting area is at least partially aligned with that of the heat emitting element, the fitting area is provided with a bump, the bump protrudes toward the heat emitting element and is in contact with the heat emitting element, the bump further has a pore, and the pore is at least located on an end surface that is of the bump and that is in contact with the heat emitting element; and
a cooling working fluid in the condenser is transmitted to the inner cavity through the second pipeline, the cooling working fluid flows back to the condenser through the first pipeline for cooling, and a part of the cooling working fluid dissipates heat for the heat emitting element at the pore of the bump.

21. The heat dissipation apparatus according to claim 20, wherein the inner cavity has a plurality of support cradles spaced from each other, two opposite ends of each support cradle are respectively fastened to the front cover and the rear cover, and the support cradles are configured to improve structural stability of the housing.

22. The heat dissipation apparatus according to claim 21, wherein there is a first distance between any two adjacent support cradles, the pore of the bump is formed by irregular arrangement of a plurality of holes, and an inner diameter of any one of the holes is less than the first distance; or
the bump comprises a plurality of protruding portions spaced from each other, gaps between the plurality of protruding portions form the pore, and a distance between any two adjacent protruding portions is less than the first distance.

23. The heat dissipation apparatus according to any one of claims 20 to 22, wherein the cooling working fluid in the condenser is transmitted to the inner cavity through the second pipeline under an action of gravity, and after dissipating heat for the heat emitting element, the cooling working fluid flows back to the condenser through the first pipeline against a gravity direction for cooling.

24. A power converter, comprising a power semiconductor device and the heat dissipation apparatus according to any one of claims 1 to 23, wherein the power semiconductor device is fastened in the inner cavity of the heat dissipation apparatus as the heat emitting element, and the heat dissipation apparatus is configured to dissipate heat for the power semiconductor device.
